# EUROPEAN PATENT SPECIFICATION

(11) **EP 1 727 186 B1**
(45) Date of publication and mention of the grant of the patent: **25.01.2012**
(21) Application number: 06252610.8
(22) Date of filing: 19.05.2006
(51) Int. Cl.: H01J 37/32

(54) **Plasma chamber with discharge inducing bridge**
Plasmakammer mit Entladung induzierender Brücke
Chambre à plasma avec un pont induisant la décharge

(30) Priority: 23.05.2005 KR 20050043232; 15.06.2005 KR 20050051638; 16.02.2006 KR 20060015143; 10.05.2006 KR 20060042062; 10.05.2006 KR 20060042073
(43) Date of publication of application: 29.11.2006
(73) Proprietor: New Power Plasma Co., Ltd., Suwon-si, Gyeonggi-do 443-390 (KR)
(72) Inventor: Choi, Dae-Kyu, Yeongtong-gu Suwon-si Gyeonggi-do 443-72 (KR); Wi, Soon-Im, Yeongtong-gu Suwon-Si 443-725 (KR)
(74) Representative: Greene, Simon Kenneth

(56) References cited:
- WO-A-01/11650
- US-A- 5 998 933
- US-A1- 2003 015 965
- US-A1- 2004 200 244
- US-B1- 6 392 351

## Description

### CROSS-REFERENCE TO RELATED APPLICATION

This application claims the benefit of Korean Patent Application No. 2005-43232, filed 23 May, 2005, Korean Patent Application No. 2005-51638, filed 15 June, 2005, Korean Patent Application No. 2006-15143, filed 16 February, 2006, Korean Patent Application No. 2006-42062, filed 10 May, 2006 and Korean Patent Application No. 2006-42073, filed 10 May, 2006.

### BACKGROUND OF THE INVENTION

The present invention relates to a radio frequency plasma source and a plasma processing system using the same.

Plasma is a gas highly ionized containing equal numbers of positive ions and electrons. Plasma discharge is used for gas excitation to an active gas containing ions, free radicals, atoms and molecules. The active gas is generally used in various fields, and typically, in semiconductor fabrication processes such as etching, deposition, cleaning and ashing.

Plasma sources for generating the plasma are various, and typical examples thereof are the capacitive coupled plasma, source and the inductive coupled plasma source, both using the radio frequency.

The capacitive coupled plasma source accurately controls the capacity and ion and has high processing productivity, compared to other plasma sources. However, since the energy of the radio frequency power is almost exclusively connected to the plasma by capacitive coupling, the plasma ion density increases or decreases based on only the increase or decrease of the radio frequency power capacitively-coupled. However, the increase of the radio frequency power increases the ion impact energy. Consequently, the radio frequency power must be limited to prevent the damage caused by ion impact.

The inductive coupled plasma source easily increases the ion density as the radio frequency power increases. In the inductive coupled plasma source, the ion impact according to the increase of the radio frequency power is relatively low. Thus, the inductive coupled plasma source is suitable to generate high-density plasma. A technique of the inductive coupled plasma source has been generally developed, by using a RF antenna and a transformer (namely, transformer coupled plasma). To improve the characteristics of the plasma and to enhance the reproductivity and control performance thereof, the method of using the RF antenna or the transformer has been further developed, by additionally using an electromagnet or a permanent magnet, or a capacitive coupled electrode.

Generally, a spiral type antenna or a cylinder type antenna is used as the RF antenna. The RF antenna is positioned outside a plasma reactor, and transfers an inductive electromotive force in the plasma reactor through a dielectric window such as quartz. The inductive coupled plasma source using the RF antenna easily generates the high-density plasma. However, the structural feature of the antenna affects the plasma uniformity in the inductive coupled plasma source. Thus, much research has been conducted to improve the structure of the RF antenna, thereby producing the uniform high-density plasma.

There is a limit in enlarging the structure of the antenna or increasing the power supplied to the antenna to obtain the large-area plasma. For example, it is known that non-uniform plasma is radially generated by a standing wave effect. Further, when high power is applied to the antenna, since the capacitive coupling of the RF antenna increases, the thickness of the dielectric window needs to be thick. Thus, since the distance between the RF antenna and the plasma becomes far, the power transfer efficiency is reduced.

In the inductive coupled plasma source using the transformer, i.e., transformer coupled plasma source, the plasma is induced in the plasma reactor by using the transformer, and the inductive coupled plasma completes a second circuit of the transformer. The techniques of the transformer coupled plasma source have been developed, by including an outer discharge tube in the plasma reactor, mounting a closed core in a toroidal chamber, or including a transformer core inside the plasma reactor.

The transformer coupled plasma source has been developed to improve the characteristics of the plasma and the energy transfer characteristics thereof, by improving the plasma reactor structure and the transformer coupling structure. Specifically, to obtain the large-area plasma, the coupling structure of the transformer and the plasma reactor is improved, a number of outer discharge tubes are included, or the number of transformer cores mounted inside the plasma reactor is increased. However, it is not easy to uniformly produce the large-area high-density plasma by merely increasing the number of the outer discharge tubes or the number of the transformer cores.

As a semiconductor device becomes super-miniaturization, a silicon wafer substrate for fabricating a semiconductor circuit becomes larger, a glass substrate for manufacturing a liquid crystal display becomes bigger, and new materials to be processed appear, a plasma processing technique must be improved in the update semiconductor fabrication industry. Specifically, a plasma source and a plasma processing technique must have its excellent processing performance with respect to a large-area workpiece to be processed.

Further, as the substrate to be processed becomes larger, the whole manufacturing equipment also becomes larger, thereby increasing the whole equipment area and consequently increasing the manufacturing cost. Thus, a plasma source and a plasma processing system must minimize the equipment area if possible.

US 5,998,933 describes a plasma processing inductor with, in one embodiment, a pair of cores extending across a plasma chamber.

### SUMMARY OF THE INVENTION

Therefore, the present invention is directed to provide a plasma processing chamber with a plasma source which generates large-area plasma, is easy to become large-area, and minimizes an equipment area.

In accordance with an exemplary embodiment, the present invention provides a plasma processing chamber according to claim 1.

Preferably, the plasma processing chamber may comprise a first impedance matching box electrically connected between the first power supply source and the primary winding.

Preferably, the plasma processing chamber may comprise a second power supply source supplying bias power to the susceptor.

Preferably, the plasma processing chamber may comprise a gas supply unit in a separate gas supply structure including a first gas supply channel for flowing a first gas to just above the discharge inducing bridges, and a second gas supply channel for flowing a second gas to between the discharge inducing bridges.

Preferably, the magnetic core may include a closed core with a single loop.

Preferably, the magnetic core may include a closed core with a multiple loops.

Preferably, the susceptor receives one or more bias power in use.

Preferably, the plasma processing chamber may comprise one or more discharge separating partitions dividing a plasma formation region formed by the discharge inducing bridges into a number of regions.

Preferably, the plasma processing chamber may comprise a ground electrode operatively positioned inside the discharge inducing bridge, to face the susceptor.

Preferably, the discharge shade may include one or more discharge separating partitions dividing the plasma formation region formed by the discharge inducing bridges into one or more regions.

### BRIEF DESCRIPTION OF THE DRAWINGS

The above and other features and advantages of the present invention will become more apparent to those of ordinary skill in the art by describing in detail preferred embodiments thereof with reference to the attached drawings in which:
FIGS. 1A and 1B are a perspective view and a sectional view of a plasma processing chamber according to a first comparative example;
FIGS. 2A and 2B are a perspective view and a sectional view of a plasma processing chamber including a number of discharge inducing bridges which are horizontally positioned in a horizontal plane.
FIGS. 3A and 3B are a perspective view and a sectional view of a cylinder-type plasma processing chamber including a number of discharge inducing bridges which are horizontally positioned in a horizontal plane;
FIGS. 4A and 4B are a perspective view and an exploded view of a plasma processing chamber including a separable chamber housing;
FIG. 5 is an example of discharge inducing bridges in which a separable magnetic core is mounted;
FIGS. 6A and 6B are a perspective view and a sectional view of a plasma processing chamber according to a second comparative example;
FIGS. 7A and 7B are a perspective view and a sectional view of a plasma processing chamber including a number of discharge inducing bridges which are horizontally positioned in a vertical plane.
FIGS. 8A, 8B and 8C are a perspective view, an exploded view and a sectional view of a plasma processing chamber according to an embodiment of the present invention;
FIGS. 9A and 9B are examples of a transformer formed by using a closed core with a multiple loop or a single loop;
FIG. 10 is an example of a discharge inducing bridge including a ground electrode;
FIG. 11 is a sectional view of a plasma processing chamber including a dual bias power;
FIGS. 12A and 12B are a dissembled view and an assembled view of a discharge separating partition;
FIGS. 13A and 13B are perspective views of a dissembled and assembled discharge shade;
FIG. 14 is a sectional view of a plasma processing chamber including a discharge shade;
FIGS. 15A through 15C are examples of a protrusion structure of a discharge shade;
FIGS. 16A and 16B are front and rear perspective views of a plasma reactor according to a third comparative example;
FIGS. 17A and 17B are examples of a multiple loop type closed core and a single loop type closed core;
FIGS. 18A and 18B are views of an electrical connection structure of a first power supply source and a primary winding;
FIG. 19 is an exploded perspective view of a reactor body, a magnetic core, and a core protecting tube;
FIG 20 is a partial cut view of a reactor body 2110 with a magnetic core 2121, a core protecting tube 2130 and a cooling channel 2131 which are mounted in a discharge chamber 2114;
FIG. 21 is an example of a cooling channel 2131 positioned along a magnetic core 2121;
FIG. 22 is a sectional view of a plasma reactor and a partial enlarged view of a discharge chamber;
FIG. 23 is an exploded perspective view of another modified plasma reactor;
FIGS. 24A and 24B are a partial cut view and a partial enlarged sectional view of a multiple discharge chamber in which a magnetic core, a core protecting tube, a cooling water supply pipe and a primary winding are mounted;
FIGS. 25A through 25C are examples of an electrical connection structure of a first power supply source and a primary winding;
FIG. 26 is an exploded perspective view of another modified plasma reactor;
FIGS. 27A through 27C are examples of an electrical connection structure of first and second power supply sources and a primary winding;
FIG. 28 is a schematic constitutional view of an atmospheric pressure plasma processing system using the plasma reactor according to the third comparative example.
FIGS. 29A through 29C are views sequentially illustrating a process of transferring a work substrate in the atmospheric pressure plasma processing system;
FIG. 30 is a schematic constitutional view of the atmospheric pressure plasma processing system in a First-In-Last-Out structure;
FIG 31 is an example of an atmospheric pressure processing unit including an electrostatic chuck:
FIGS. 32A and 32B are examples of a plasma reactor horizontally positioned;
FIG. 33A is a perspective view of a plasma processing chamber using the plasma reactor according to the third comparative example.
FIG. 33B is a sectional view of a plasma processing chamber and a partial enlarged view of a discharge chamber;
FIG 34 is a sectional view of a reactor body having a separated gas supply structure;
FIG. 35 is a schematic constitutional view of a plasma processing system; and
FIGS. 36A through 36C are views sequentially illustrating a process of transferring a work substrate in a plasma processing system.

### DETAILED DESCRIPTION OF THE INVENTION

A plasma source with a discharge inducing bridge and a plasma processing system using the same of the present invention will now be described more fully with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art. In the drawings, the shape of components may be exaggerated for clarity. Like numbers refer to like elements throughout the specification. Where the function and structure are well-known in the relevant arts, further discussion will not be presented in the detailed description or illustration of the present invention in order not to unnecessarily make the gist of the present invention unclear.

### Comparative example I

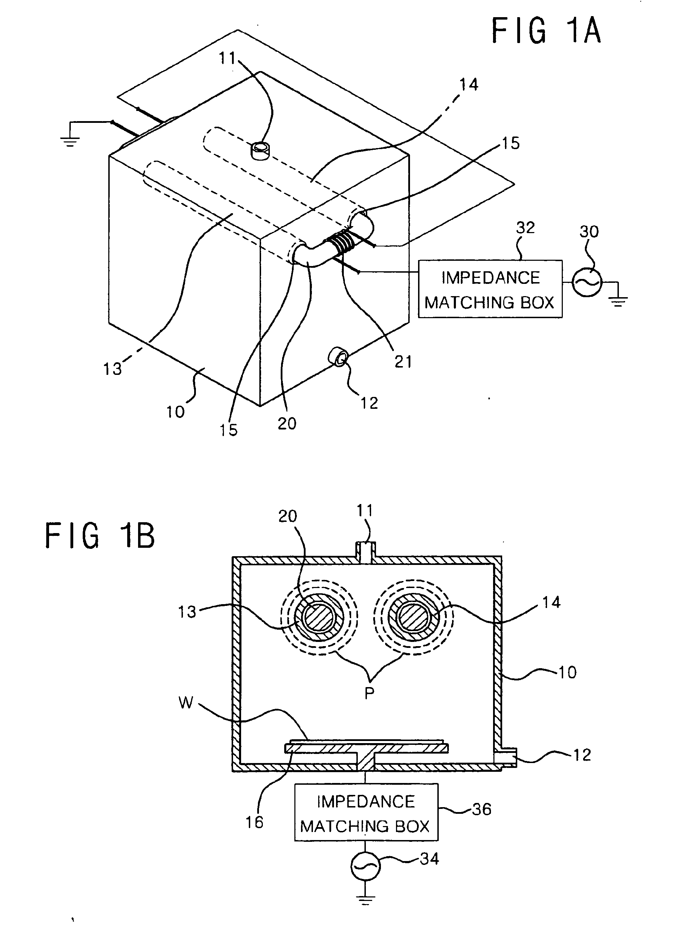

FIGS. 1A and 1B are a perspective view and a sectional view of a plasma processing chamber according to a first comparative example. The plasma processing chamber includes a chamber housing 10 and two discharge inducing bridges 13 and 14 positioned inside the chamber housing 10. The discharge inducing bridges 13 and 14 are linear hollow tubes. A toroidal magnetic core 20 is mounted in the discharge inducing bridges 13 and 14, and the magnetic core 20 with a winding coil 21 forms a transformer. The winding coil 21 is electrically connected to a power supply source 30 supplying radio frequency to the primary winding of the transform, through an impedance matching box 30.

The chamber housing 10 includes a number of holes 15 formed in two sidewalls opposed to each other. Both ends of each of the discharge inducing bridges 13 and 14 are connected to the holes 15. A passage within the chamber housing 10 from the outside of the chamber housing 10 is provided through the hollow regions of the discharge inducing bridges 13 and 14 and two pairs of holes 15.

A gas entrance 11 is formed in the ceiling of the chamber housing 10, and a gas exit 12 is formed in a sidewall or bottom thereof. A susceptor 16 on which a work substrate W is placed is positioned inside the chamber housing. Preferably, the gas entrance 11 may be formed above the discharge inducing bridges 13 and 14, so that a processing gas inputting through the gas entrance 11 jets above the discharge inducing bridges 13 and 14 and evenly spreads and flows downward the chamber housing 10. Although not shown in the drawings, the gas entrance 11 is connected to a gas supply source supplying the processing gas, and the gas exit 12 is connected to a vacuum pump.

The chamber housing 10 is made of a metal material such as aluminum, stainless, or copper. Alternatively, it may be made of a coated metal, for example, anodized aluminum or aluminum coated with nickel. Alternatively, it may be made of a refractory metal. The housing chamber 10 may be made of other materials suitable to process the intended plasma.

Two discharge inducing bridges 13 and 14 are horizontally positioned in a horizontal plane within the chamber housing 10, from a first sidewall of the chamber housing 10 to a second sidewall opposed to the first sidewall. The discharge inducing bridges 13 and 14 which are the hollow tubes substantially cover and protect the magnetic core 20 positioned inside the chamber housing 10.

The discharge inducing bridges 13 and 14 are made of an electrical insulating material such as quartz or ceramic. Alternatively, the discharge inducing bridges 13 and 14 may be made of a metal material, like the chamber housing 10. In this case, to prevent the eddy current, it is preferable to include an insulation region including the electrical insulating material to have the electrical discontinuity. Although not shown in the drawings, a cooling channel controlling the temperature of the discharge inducing bridges 13 and 14 is positioned between the discharge inducing bridges 13 and 14 and the magnetic core 20.

The magnetic core 20 has a closed core structure of a single loop. The magnetic core 20 is made of a ferrite material but it may be made of other materials such as iron or air. The magnetic core 20 is mounted in two discharge inducing brides 13 and 14. Substantially, most of the magnetic core 20 is positioned inside the chamber housing 10, and small parts thereof protrudes outward at two sidewalls of the chamber housing 10 opposed to each other.

The magnetic core 20 is wound with the winding coil 21, thereby forming the transformer. Preferably, two winding coils 21 are wound around the two parts of the magnetic core 20 protruding outward at two sidewalls of the chamber housing 10 opposed to each other, respectively. Alternatively, the winding coil 21 may be wound around only any one of the outward protruding parts of the magnetic core 20. Alternatively, the winding coil 21 may be wound around the portion of the magnetic core 20 positioned inside the chamber housing 20. The winding coil 21 is electrically connected to the power supply source 30 supplying the radio frequency. The winding coils 21 are connected to the power supply source 30 in series, but may be connected in parallel.

The power supply source 30 is an alternate current (AC) power supply source supplying the RF power. The impedance matching box 32 for impendence matching is positioned at an output terminal of the power supply source 30. However, a RF power supply source capable of controlling the output voltage without a separate impedance matching box may be used. The susceptor 16 is electrically connected to the power supply source 34 supplying the bias power, through the impedance matching box 36.

When the RF power is supplied to the winding coil 21 by the power supply source 30, the current is driven at the winding coil 21 and the magnetic flux is induced to the magnet core 20 in the plasma processing chamber, thereby inducing an AC potential inside the chamber housing 20, for forming inductive coupled plasma around the discharge inducing bridges 13 and 14, i.e., for completing a secondary circuit of the transformer. The plasma discharge is evenly induced in parallel, along two discharge inducing bridges 13 and 14, thereby generating uniform high-density plasma inside the chamber housing 20.

Further, since the surface of the discharge inducing bridges 13 and 14 is revealed inside the chamber housing 10, equipment cleaning is very easy, thereby increasing the cleaning efficiency and shortening the cleaning time. Consequentially, the productivity is generally improved. Specifically, to obtain a required volume of plasma, a plasma processing chamber may be easily extended and changed by increasing the number of discharge inducing bridges according to the size of a work substrate, as described below:

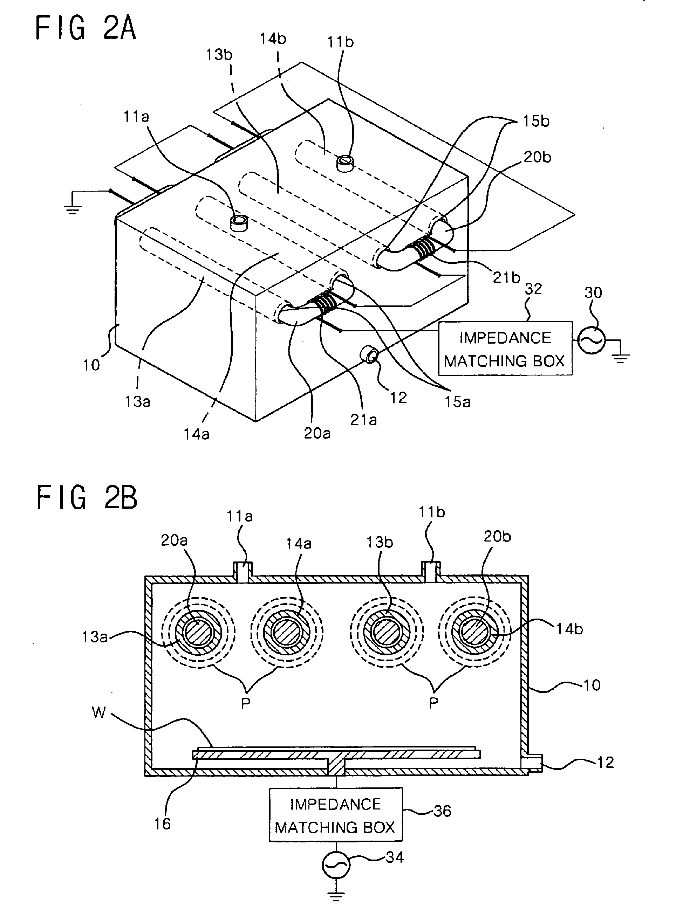

FIGS. 2A and 2B are a perspective view and a sectional view of a plasma processing chamber including a number of discharge inducing bridges horizontally positioned in a horizontal plane. The plasma processing chamber includes four discharge inducing bridges 13a, 14a, 13b and 14b inside a chamber housing 10. Four discharge inducing bridges 13a, 14a, 13b and 14b are horizontally positioned in a horizontal plane at an upper part in the chamber housing 10. A number of holes 15a and 15b are formed in two sidewalls of the chamber housing 10 opposed to each other, and are connected to both ends of each of four discharge inducing bridges 13a, 14a, 13b and 14b.

Two gas entrances 11a and 11b may be formed in the ceiling of the chamber housing 10. Preferably, the gas entrances may be positioned above four discharge inducing bridges 13a, 14a, 13b and 14b, respectively. A processing gas jets above four discharge inducing bridges 13a, 14a, 13b and 14b, and evenly spreads and flows downward the chamber housing 10.

Two magnetic cores 20a and 20b are mounted in four discharge inducing bridges 13a, 14a, 13b and 14b. A number of winding coils 21a and 21 b are wounded around two magnetic cores 20a and 20b, respectively, and are electrically connected to a power supply source 30 through a first impedance matching box 32. The winding coils 21a and 21b may be electrically connected to the power supply source 30 in series, in parallel or in a series and parallel combination. Alternatively, the winding coils 21a and 21 b may be connected to two or more independent power supply source and impedance matching boxes, thereby having the independent power supply structure.

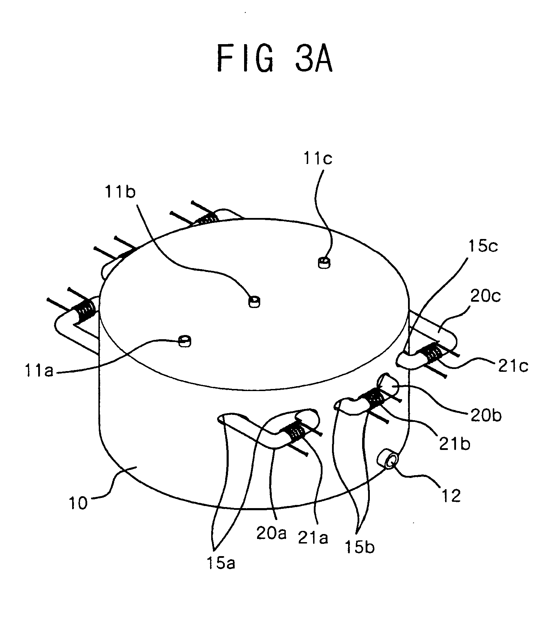

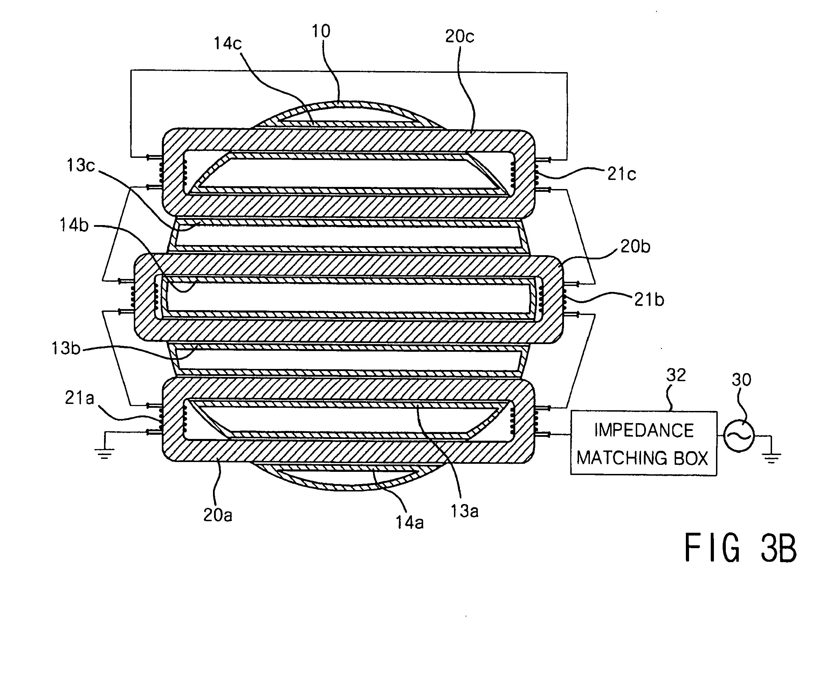

FIGS. 3A and 3B are a perspective view and a sectional view of a cylinder-type plasma processing chamber including a number of discharge inducing bridges which are horizontally positioned in a horizontal plane. Another modified plasma processing chamber includes six discharge inducing bridges 13a, 14a, 13b, 14b, 13c and 14c. The six discharge inducing bridges 13a, 14a, 13b, 14b, 13c and 14c are horizontally positioned in a horizontal plane at an upper part in a chamber housing 10. The chamber housing 10 has a cylinder-type structure, and six discharge inducing bridges 13a, 14a, 13b, 14b, 13c and 14c have their respective different length in accordance with the cylinder-type structure of the chamber housing 10. A number of holes 15a, 15b and 15c are formed in two sides of the chamber housing 10 opposed to each other, and are connected to both ends of each of six discharge inducing bridges 13a, 14a, 13b, 14b, 13c and 14c.

Three gas entrances 11 a, 11 b and 11c may be formed in the ceiling of the chamber housing 10. Preferably, the gas entrances 11a, 11 b and 11c may be positioned above the discharge inducing bridges 13a, 14a, 13b, 14b, 13c and 14c. A processing gas inputting through the gas entrances 11a, 11b and 11c jets above each of the discharge inducing bridges 13a, 14a, 13b, 14b, 13c and 14c, and evenly spreads and flows downward the chamber housing 10.

Three magnetic cores 20a, 20b and 20c are mounted in six discharge inducing bridges 13a, 14a, 13b, 14b, 13c and 14c. A number of winding coils 21a, 21 b and 21 c are wound around the magnetic cores 20a, 20b and 20c, and are electrically connected to a power supply source 30, through a first impedance matching box 32. The winding coils 21a, 21b and 21c may be connected to the power supply source 30 in series, in parallel or in a series and parallel combination. Alternatively, the winding coils 21a, 21 b and 21 c may be connected to two or more independent power supply source and impedance matching boxes, thereby having the independent power supply structure.

As described above, the plasma processing chamber is easily changed to generate large-area plasma, by increasing the number of discharge inducing bridges coupled with the transformer and extending the respective length thereof. Further, the length, shape and position structure of the discharge inducing bridges may be modified according to the structural features of the plasma processing chamber. The structure or number of the gas entrances may be appropriately modified to form uniform plasma. The number of the susceptors positioned inside the chamber housing may be increased to process a multiple substrate.

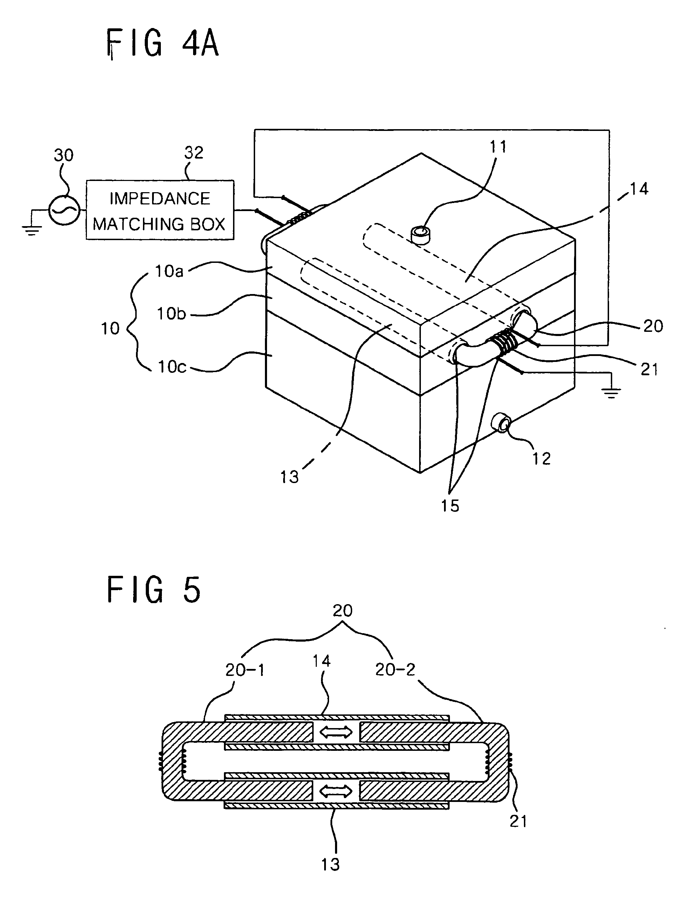

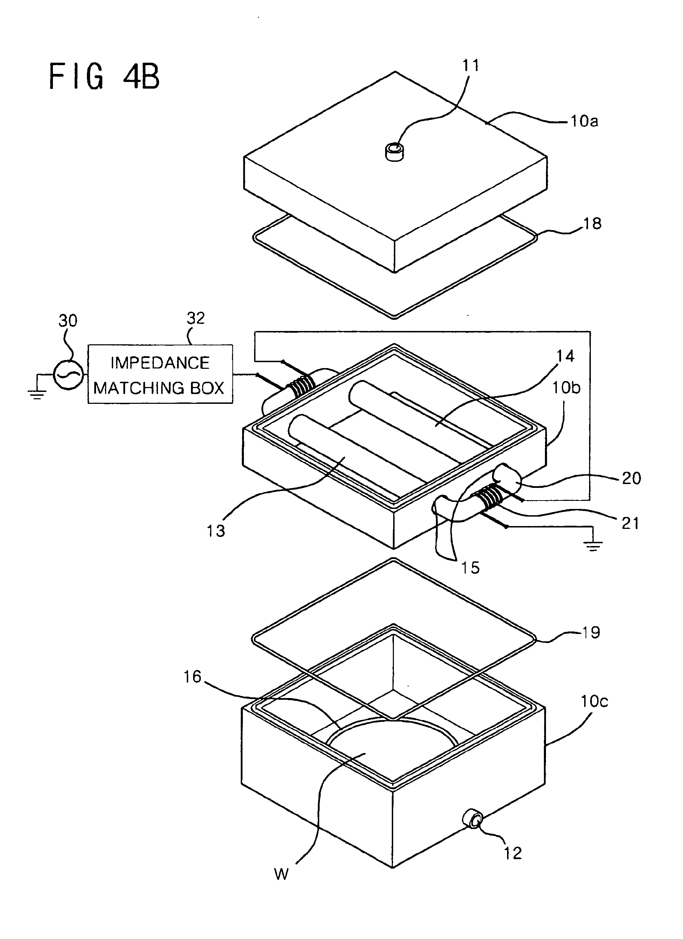

FIGS. 4A and 4B are a perspective view and an exploded view of a plasma processing chamber including a separable chamber housing. In another modified plasma processing chamber, a chamber housing 10 is separable as an upper housing 10a, a middle housing 10b and a lower housing 10c. O-rings 18 and 19 for vacuum-insulation are inserted at each connection portion between two adjacent housings. Discharge inducing bridges 13 and 14 are positioned inside the middle housing 10b. The middle housing may be integrally formed with the discharge inducing bridges 13 and 14.

FIG. 5 is an example of discharge inducing bridges in which a separable magnetic core is mounted. A magnet core 20 mounted in discharge inducing bridges 13 and 14 has two horseshoe shapes and may include separable first and second magnetic cores 20-1 and 20-2 to control the distance therebetween. As the distance between the first and second magnetic cores 20-1and 20-2 is controlled, the characteristic of an inductive electromotive force transferred to the inside of the chamber housing 10 is controlled, thereby controlling the characteristic of the plasma generated inside the chamber housing 10.

### Comparative Example II

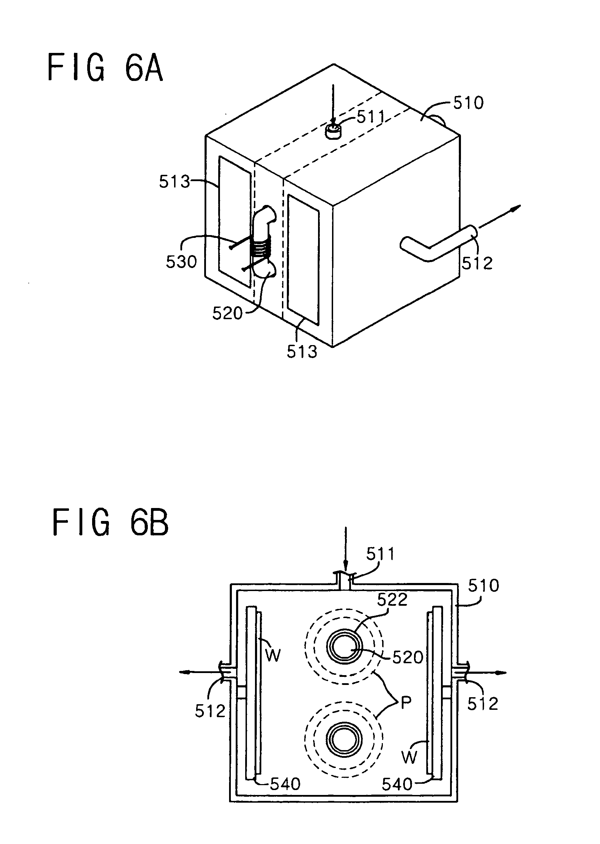

FIGS. 6A and 6B are a perspective view and a sectional view of a plasma processing chamber according to a second comparative example. The plasma processing chamber generates the inductive coupled plasma P in the same manner as the plasma processing chamber described above. Thus, a repeated description thereof will not be presented.

In the plasma processing chamber, two susceptors 540 are positioned at two sidewalls opposed to each other inside a chamber housing 510. Two discharge inducing bridges 522 are horizontally positioned in a vertical plane and equally spaced apart from two susceptors 540. A magnetic core 520 with a winding coil 520 is mounted in the discharge inducing bridges 522.

A gas entrance 511 is formed in the ceiling of the chamber housing 510. Preferably, the gas entrance 510 is positioned above the discharge inducing bridges 522, so that a processing gas inputting through the gas entrance 511 jets above the discharge inducing bridges 522, and evenly spreads and flows downward the chamber housing 10. Two gas exits 512 are formed in the two sidewalls of the chamber housing, where the chamber susceptors 540 are positioned, thereby having a separate exhaust structure.

The plasma processing chamber of the second example has the plasma generating structure described with reference to the first example. But, the plasma processing chamber according to the second example is effective in reducing the equipment width by its structural features such that the discharge inducing bridges 522 are positioned to be perpendicular to the inner center of the chamber housing 510, two susceptors are vertically positioned at two sidewalls, so as to be around the discharge inducing bridges 522 and to process two sheets of the work substrates W vertically positioned.

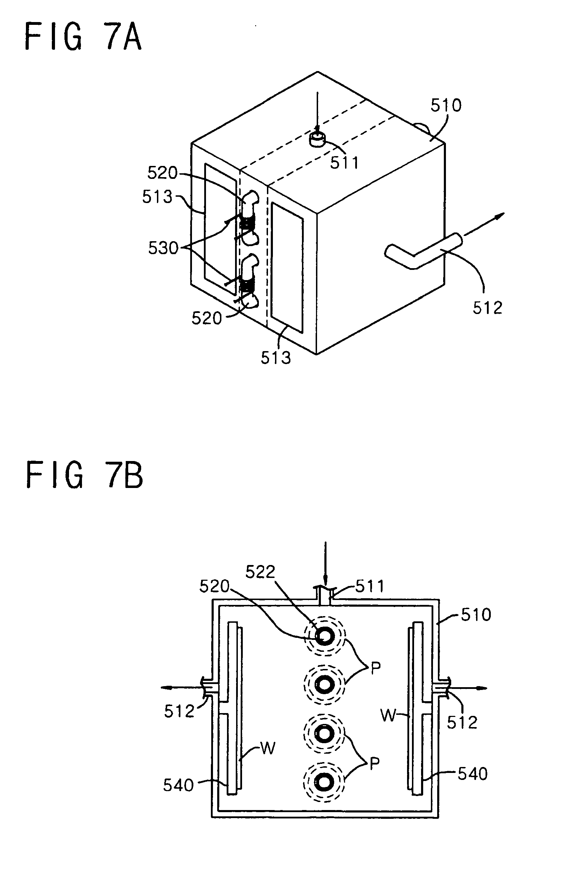

FIGS. 7A and 7B are a perspective view and a sectional view of a plasma processing chamber including a number of discharge inducing bridges. As illustrated in the drawings, another modified plasma processing chamber according to the second embodiment includes four discharge inducing bridges 522 which are horizontally positioned in a vertical plane inside a chamber housing 510. The number of discharge inducing bridges 522 may be increased to generate the large-area plasma.

Like the plasma processing chamber of the first comparative example, the plasma chamber of the second comparative example may be easily modified by increasing the number of discharge inducing bridges coupled with a transformer and extending the length of the discharge inducing bridges, to generate the large-area plasma. Further, the length, shape and position structure of the discharge inducing bridges may be modified according to the structural features of the plasma processing chamber. The structure or number of the gas entrance may be appropriately modified to form uniform plasma.

### Embodiment

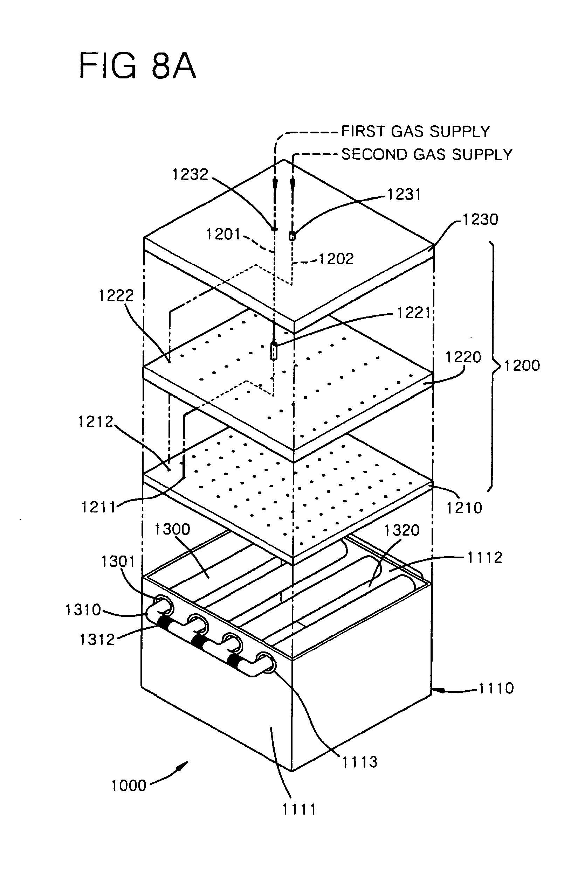

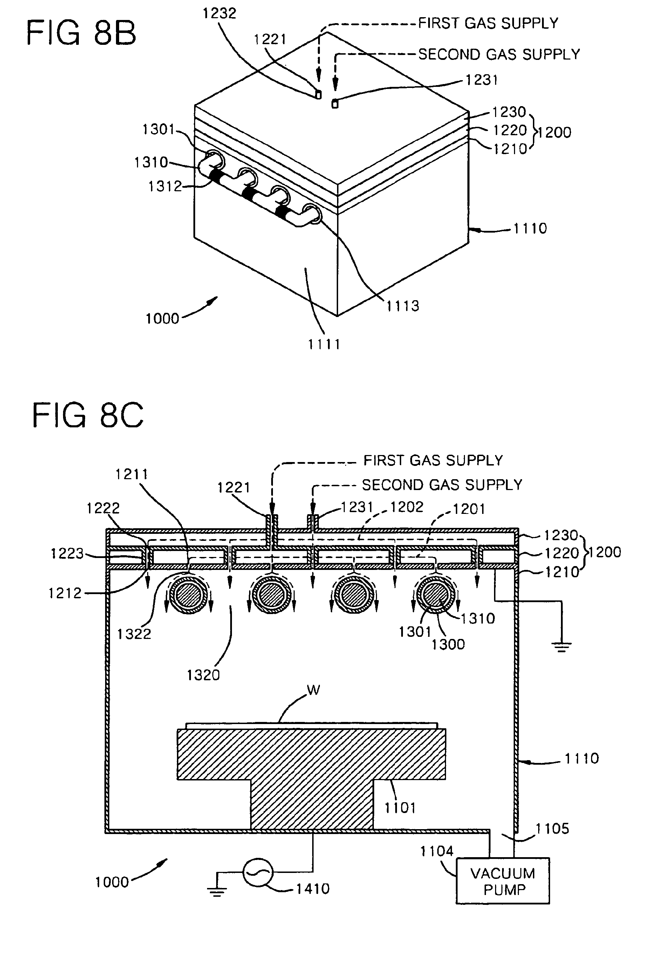

FIGS. 8A, 8B and 8C are a perspective view, an exploded view and a sectional view of a plasma processing chamber 1000 according to an embodiment of the present invention. The plasma processing chamber 1000 includes a chamber housing 1110 having a susceptor 1101 on which a work substrate W is placed; and a gas supply unit 1200 positioned on the chamber housing 1110.

A number of discharge inducing bridges 1300 are horizontally positioned in a horizontal manner at an upper part of the chamber housing 1110, from a first sidewall 1111 of the chamber housing 1110 to a second sidewall 1112 opposed to the first sidewall 1111, above the susceptor 1101. A gas exit 1105 is positioned at a lower part of the chamber housing 1110 and is connected to a vacuum pump 1104.

Holes 1113 are formed in the two sidewalls 1111 and 1112 of the chamber housing 1110, from and to which the discharge inducing bridges 1300 are connected. The holes 1113 receive both ends of each discharge inducing bridge 1300. A hollow region 1301 of each discharge inducing bridge forms a passage within the chamber housing 1110. A magnetic core 1310 with a winding coil (primary winding) 1312 is embedded in the hollow region 1301. The magnetic core 1310 with the winding coil 1312 forms a transformer.

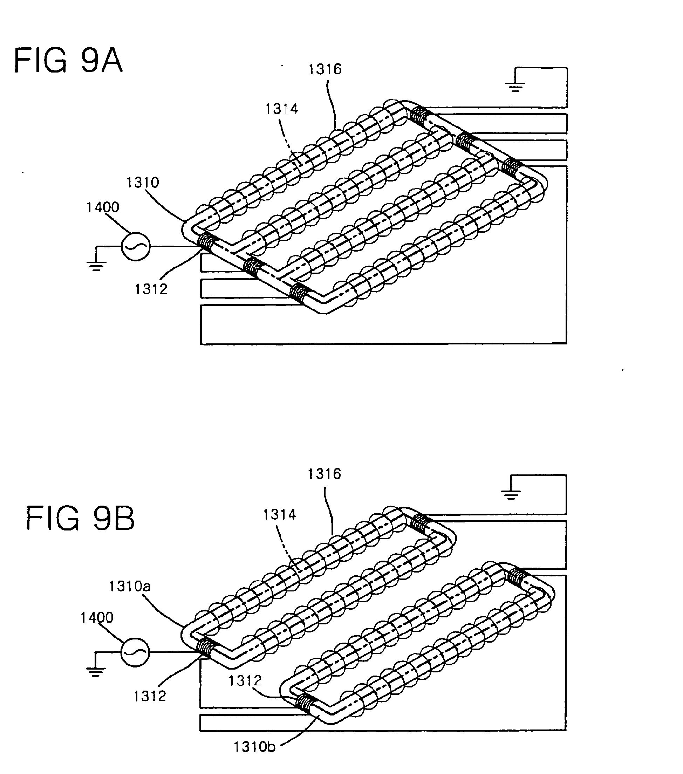

FIGS. 9A and 9B are examples of a transformer formed by using a closed core with a multiple loop or a single loop. As shown in FIG. 9A, a magnetic core 1310 mounted in each discharge inducing bridge 1300 is a closed core structure having the multiple loop. A winding coil 1312 wound around the magnetic core 1310 is wound around each loop. As shown in FIG. 9B, the magnetic core 1310 may include a number of closed cores 1310a and 1310b, each closed core having a single loop.

A number of winding coils 1312 are electrically connected to a first power supply source 1400 supplying the RF power. The winding coils 1312 may be electrically connected to the first power supply source 1400 in series, in parallel or a series and parallel combination. As not shown in the drawing, an impedance matching box is positioned between a number of the winding' coils 1312 and the first power supply source 1400. However, the RF power supply source capable of controlling the output voltage without a separate impedance matching box may be used. A susceptor 1101 is electrically connected to a second power supply source 1410 supplying the bias power. For this, the RF power supply source capable of controlling the output voltage without a separate impedance matching box may be also used.

When an alternate current (AC) power of a first frequency is supplied from the first power supply source 1400 to the winding coil 1312, magnetic flux 1314 is induced along the multiple loop of the magnetic core 1310. An inductive electric field 1316 is formed to cover the discharge inducing bridges 1300. Thus, plasma discharge is formed around the discharge inducing bridges 1300 inside the chamber housing 1110.

Again referring to FIGS. 8A through 8C, the gas supply unit 1200 has a separate gas supply structure, thereby enabling more uniform high-density plasma. The gas supply unit 1200 includes a gas jet plate 1210, a gas distribution plate 1220 and a upper cover 1230, which are vacuum-insulated and sequentially stacked on the chamber housing 1110. Each interlayer is vacuum-insulated.

The gas jet plate 1210 includes first and second gas supply channels 1211 and 1212, and is electrically grounded. The first gas supply channel 1211 includes a number of through holes linearly positioned, along the longitudinal direction of the upper region 1322 of the discharge inducing bridges 1300. The second gas supply channel 1212 includes a number of through holes linearly positioned, along the longitudinal direction of the region 1320 between the discharge inducing bridges 1300.

The gas distribution plate 1220 includes a number of through holes 1222. The through hole 1222 are regularly formed above the second gas supply channel 1212 and correspond to the through holes of the second gas supply channel 1212. The gas distribution plate 1220 includes a first gas entrance 1221 receiving a first processing gas and exhausting the first processing gas above the gas jet plate 1210.

The upper cover 1230 covers the upper part of the gas distribution plate 1220 and includes a second gas entrance 1231 receiving a second processing gas. The upper cover 1230 includes one through hole 1232 at a position corresponding to the first gas entrance 1221.

The gas supply unit 1200 forms one first gas supply passage 1201 from the first gas entrance 1221 to the first gas supply channel 1211, and one second gas supply passage 1202 from the second gas entrance 1231 to the second gas supply channel 1212.

The first processing gas flows toward the upper region 1322 of the discharge inducing bridges 1300, and the second processing gas flows toward the region 1320 between the discharge inducing bridges. The first processing gas forms the plasma before the second processing gas, while flowing toward the upper region 1322 of the discharge inducing bridges 1300. The first processing gas is mixed with the second processing gas in an ionized state. The first processing gas may be, for example, Ar, N₂ or O₂ as a carrier gas. The second processing gas may be SiH₄, CH₄, CH₃ or Cl ₂ as a source gas.

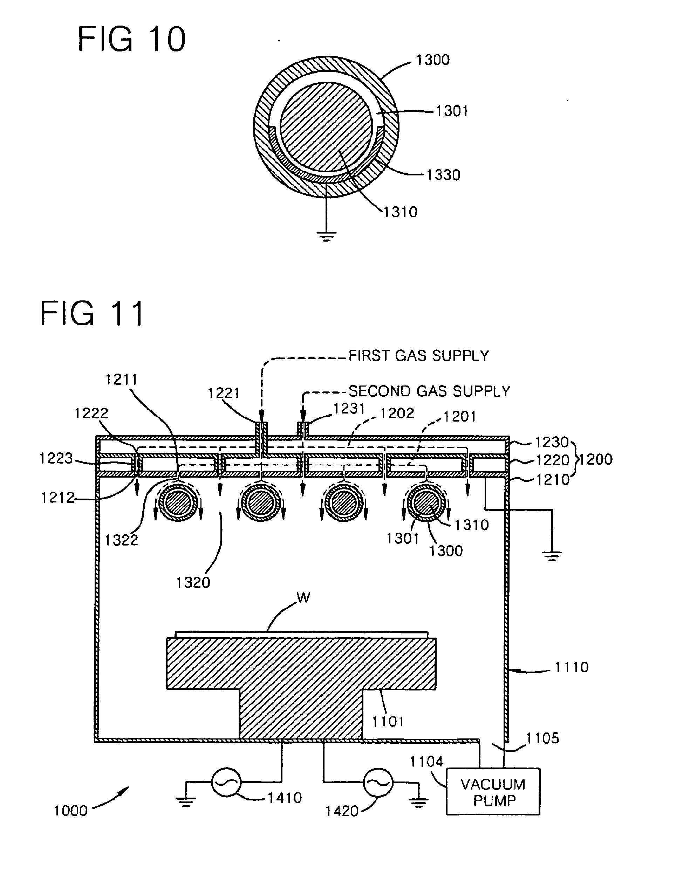

The susceptor 1101 is electrically connected to the second power supply source 1410 supplying the bias power of a second frequency. The bias applied to the susceptor 1101 is discharged toward the gas jet plate 1210 connected to the ground. Since the discharge inducing bridges 1300 are positioned in the discharge path, thereby interrupting the uniform discharge. The discharge inducing bridge 1300 includes a ground electrode 1330 positioned longitudinally at a lower part of the discharge inducing bridge 1300, to face the susceptor 101, as illustrated in FIG. 10.

FIG. 11 is a sectional view of a plasma processing chamber including a dual bias power. A susceptor 1101 is electrically connected to a second power supply source 1410 supplying the bias power of a second frequency, and is electrically connected to a third power supply source 1420 supplying the bias power of a third frequency. The second frequency is different from the third frequency.

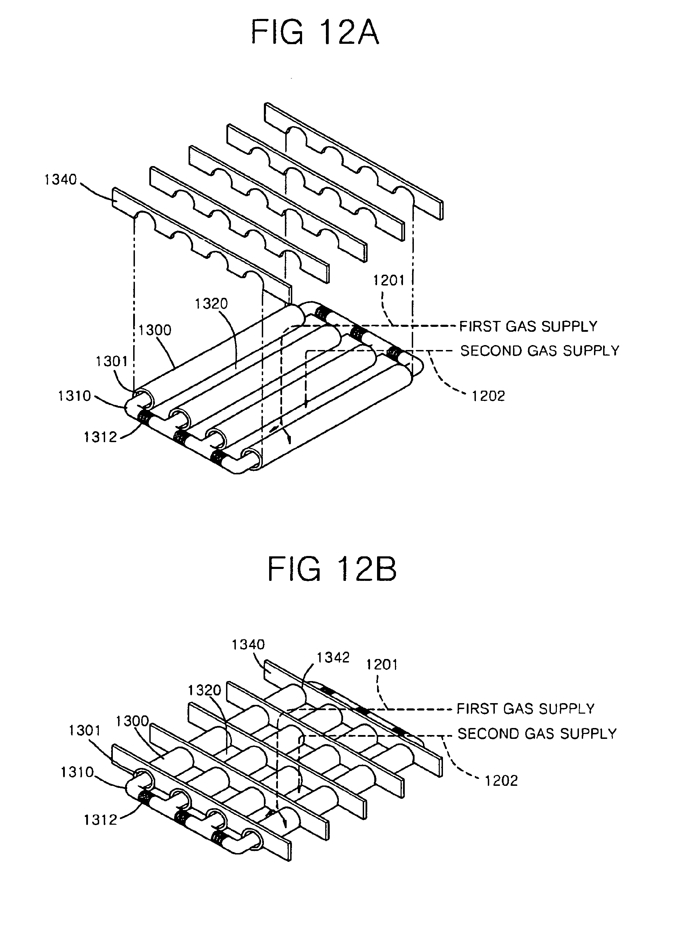

FIGS. 12A and 12B are a dissembled view and an assembled view of a discharge separating partition. In a plasma processing chamber 1000, the plasma discharge is formed along discharge inducing bridges 1300. Here, a number of divided discharge separating partitions 1340 may be used to prevent the plasma discharge from biasing. The divided discharge separating partitions 1340 are mounted so as to be at right angles to the longitudinal direction of the discharge inducing bridges 1300, so that the plasma formation region is divided into many. As a result, uniform plasma discharge is formed on the whole. The discharge separating partitions 1340 include an insulating material or a metal material.

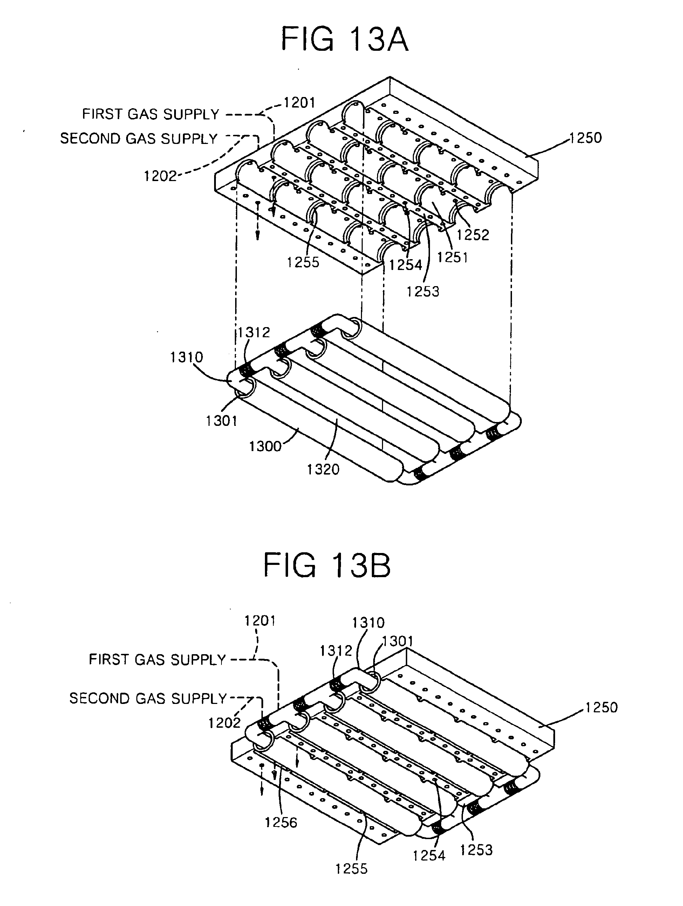

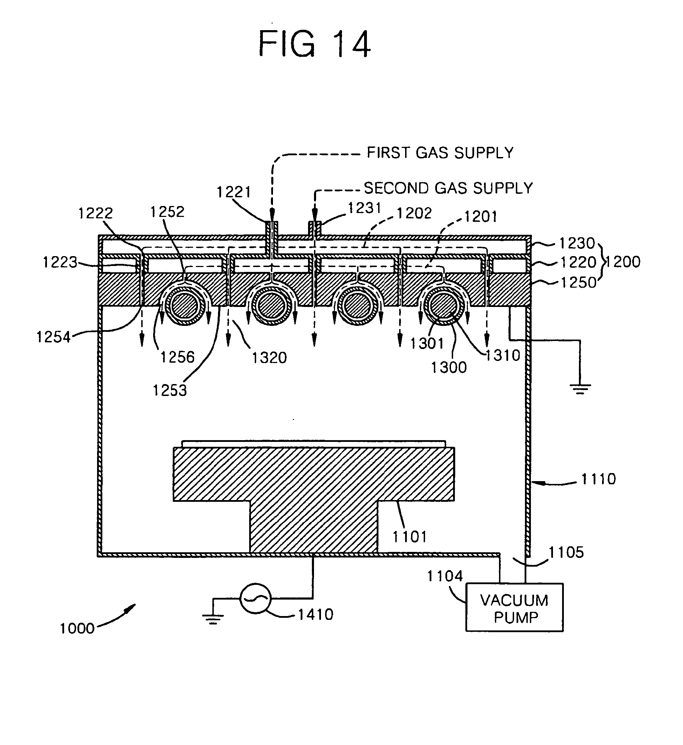

FIGS. 13A and 13B are perspective views of a dissembled and assembled discharge shade. FIG. 14 is a sectional view of a plasma processing chamber including a discharge shade. Another modified plasma processing chamber 1000 includes a gas supply unit 1200 with a discharge shade 1250 to be positioned on the discharge inducing bridges 1300.

The discharge shade 1250 is positioned between a gas distribution plate 1220 and a chamber housing 1110. The discharge shade 1250 includes first and second gas supply channels 1252 and 1254 which are alternately formed, like the gas jet plate 1210 shown in FIG. 11.

The discharge shade 1250 surrounds each discharge inducing bridge 1300 at a predetermined interval, and its portions facing a susceptor 1101 is opened along each discharge inducing bridge 1300 and is electrically grounded. The discharge shade 1250 has a dome strucutre 1251 at each portion corresponding to each discharge inducing bridge 1300, and a protrusion 1253 at each region 1320 between the discharge inducing bridges 1300. The first gas supply channel 1252 is formed along the dome structure 1251, and the second gas supply channel 1254 is formed along the protrusion 1253. A narrow discharge region 1256 is formed between the discharge inducing bridge 1300 and the dome structure 1251 of the discharge shade 1250. To prevent partial discharge and to form more uniform discharge, a number of discharge separating partitions 1255 may be formed in the region of the dome structure 1251.

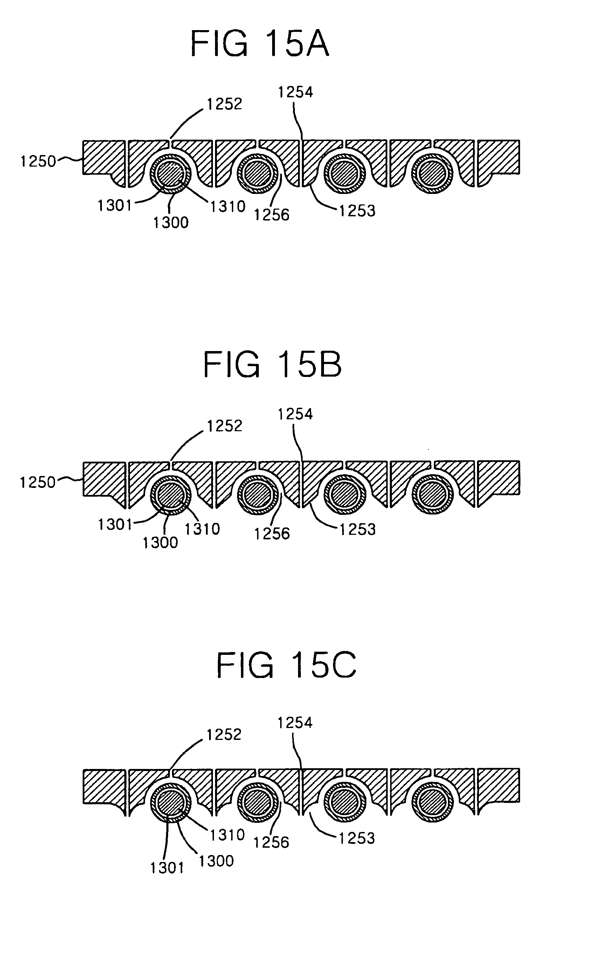

While a first processing gas passes through the narrow discharge region 1256, the plasma discharge is formed. Since the protrusion 1251 of the discharge shade 1250 protrudes toward the susceptor 1101, more stable discharge is formed by bias. The shape of the protrusion 1251 may be variously modified and carried out, as shown in FIGS. 15A through 15C.

As described above, the plasma processing chamber according to the third embodiment includes the dual gas supply structure which is suitable for the unique discharge structure with a number of discharge inducing bridges. In addition, the large-area high-density plasma is uniformly generated, by providing the electrode grounded to the discharge separating partitions or discharge shade and the discharge inducing bridges.

### Comparative Example III

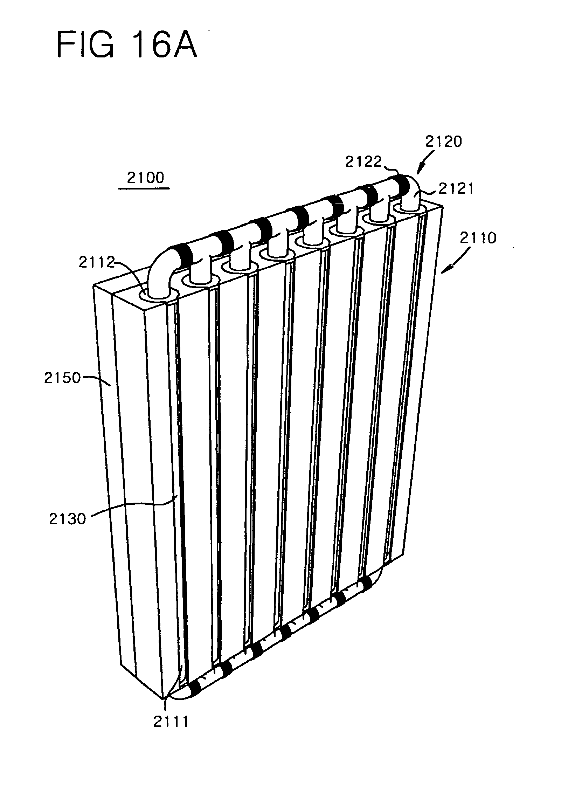

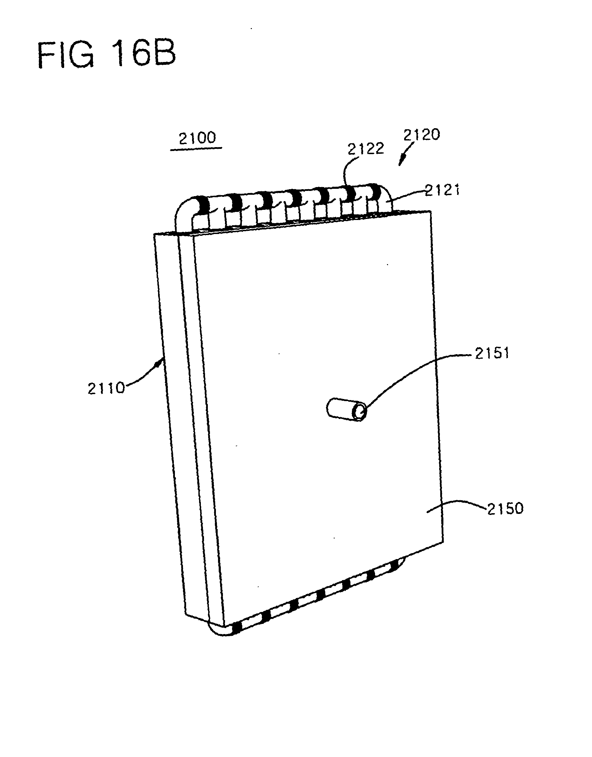

FIGS. 16A and 16B are front and rear perspective views of a plasma reactor 2100 according to a third comparative example. The plasma reactor 2100 includes a reactor body 2110 with a number of discharge chambers 2114 which are vertically positioned in a vertical plane. The reactor body 2110 includes a number of plasma jet slits 2111 which are opened, along the discharge chambers 2114, at the front side of the reactor body 2110, to output plasma. A gas supply unit 2150 supplying a gas to the discharge chambers 2114 is positioned at the rear side of the reactor body 2110. The gas supply unit 2150 includes a gas entrance 2151 connected to a gas source (not shown).

The reactor body 2110 has a vertically standing square block shape. The shape of the reactor body 2110 may be various according to the shape of the work to be processed. For example, to process a workpiece in a discus shape, a reactor body may have a round shape on the whole, by forming the length of the discharge chambers 2114 so as to be different from one another.

In the reactor body 2110, a number of the discharge chambers 2114 are vertically positioned in a vertical plane. The comparative example uses eight discharge chambers 2114, but the number of the discharge chambers may be less or more than eight. The length and number of the discharge chambers 2114 may decrease or increase according to the area of the workpiece to be processed. The plasma reactor 2100 may include at least one or two discharge chambers 2114.

The reactor body 2110 is made of a metal material such as aluminum, stainless or copper. Alternatively, it may be made of a coated metal, for example, anodized aluminum or aluminum coated with nickel, Alternatively, it may be made of a refractory metal. Further, alternatively, the whole reactor body 2110 may be made of an electrical insulating material such as quartz and ceramic, or other materials suitable for an intended plasma processing.

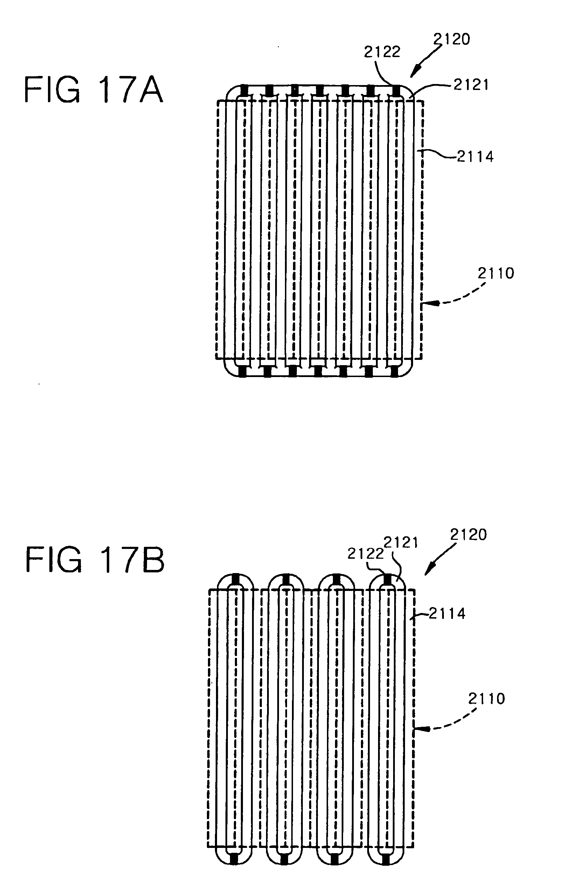

FIGS. 17A and 17B are examples of a multiple loop type closed core and a single loop type closed core. Referring to FIG. 17A, a magnetic core 2121 is longitudinally positioned through a number of the discharge chambers 2114. The magnetic core 2121 with a primary winding 2122 forms a transformer 2120. The magnetic core 2121 is made of a ferrite material, but may be made of other alternative materials such as iron or air. The magnetic core 2121 includes a multiple loop generally shared in a number of the discharge chambers 2114. Or, the magnetic core 2121 may include a single loop shared in two discharge chambers 2114 as shown in FIG. 17B. Or a single loop type closed core may be mounted in one discharge chamber 2114.

Most of the magnetic core 2121 is positioned in the discharge chambers 2114, and parts thereof are exposed outside the discharge chambers 2114. The primary winding 2122 is wound around the exposed parts. The primary winding 2122 includes a number of winding coils wound around the loops of the magnetic core 2121, respectively. The winding coil may be wound around every other loop. A number of winding coils are wound in the direction not to collide with the direction of the magnetic flux formed along every loop of the magnetic core 2122.

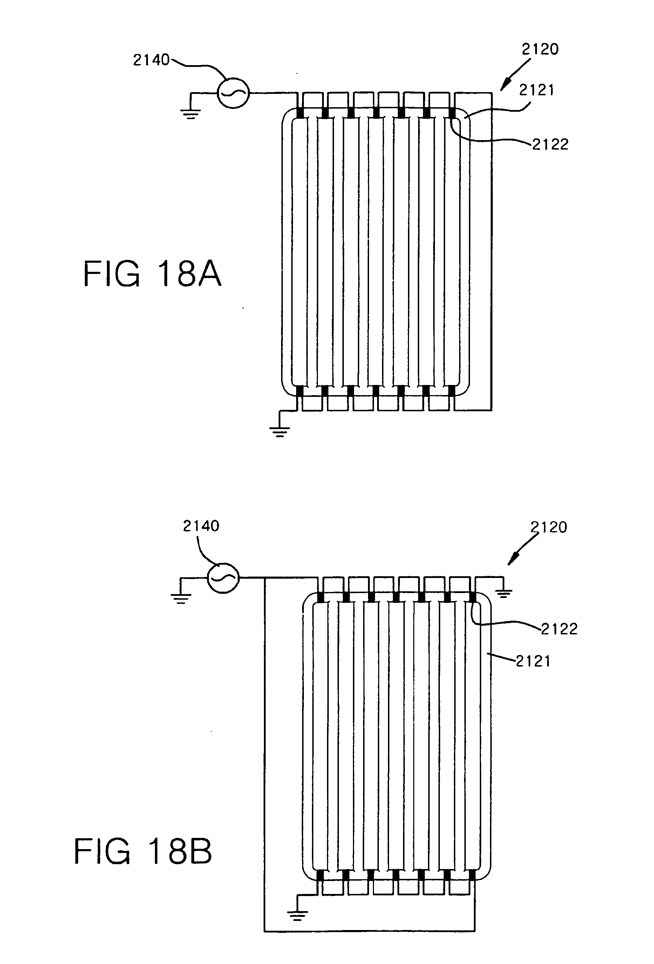

FIGS. 18A and 18B are views of an electrical connection structure of a first power supply source 2140 and a primary winding 2122. Referring to FIG. 18A, a number of winding coils forming the primary winding 2122 may be connected to the first power supply source 2140 in series. Alternatively, as shown in FIG. 18B, a number of winding coils at the upper and lower portions of the magnetic core 2121 may be connected in parallel to the first power supply source 2140. A number of winding coils may be connected by any one selected from various electrical connection methods such as series, parallel, and a series/parallel combination.

The first power supply source 2140 is an alternating current (AC) power supply source supplying the RF power. Although not shown in the drawings, an impedance matching box for impedance matching may be positioned at an output terminal of the first power supply source 2140. However, those skilled in this art may understand that the RF power supply source capable of controlling the output voltage without a separate impedance matching box may be used.

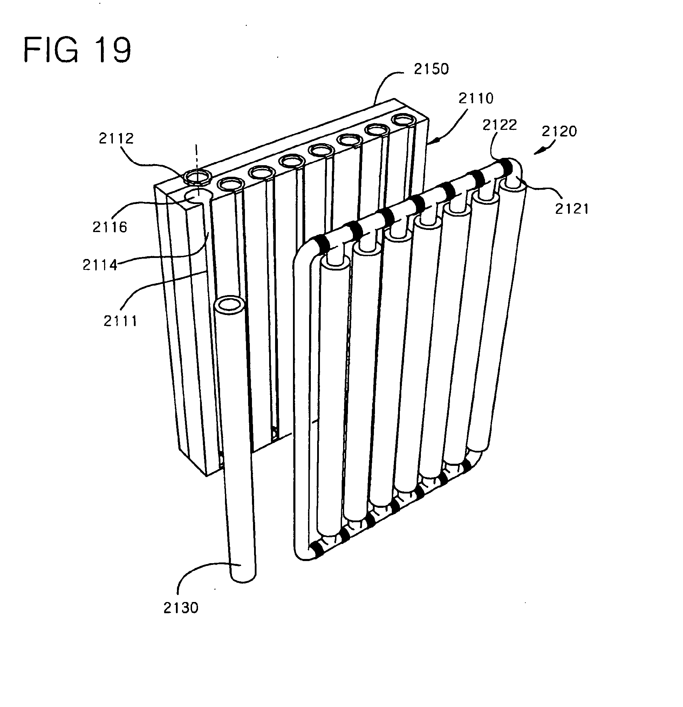

FIG. 19 is an exploded perspective view of a reactor body 2110, a magnetic core 2121 and a core protecting tube 2130. A number of discharge chambers 2114 have a cylinder shape, respectively, and are vertically positioned in a vertical plane, from the upper portion of the reactor body 2110 to the lower portion thereof. Cover member 2112 covers both ends of each discharge chamber 2114, respectively. The cover member 2112 is made of an insulating material such as quartz or ceramic. Or, it may be made of the same metal material as the reactor body 2110. When the cover member 2112 is made of the same metal material as the reactor body 2110, preferably, the cover member 2112 may include an insulation region to have the electrical discontinuity, thereby preventing the eddy current.

The core protecting tube 2130 protectively covers the portion of the magnetic core 2121 to be positioned in the discharge chambers 2114. The core protecting tube 2130 has the same constitution as the discharge inducing bridges of the first and second comparative examples and of the embodiment. The core protecting tube 2130 is made of an electrical insulating material such as quarts or ceramic. Alternatively, the core protecting tube 2130 may be made of the same metal material as the reactor body 2110, and in this case, it includes an insulation region of the electrical insulating material so as to have the electrical discontinuity to prevent the eddy current.

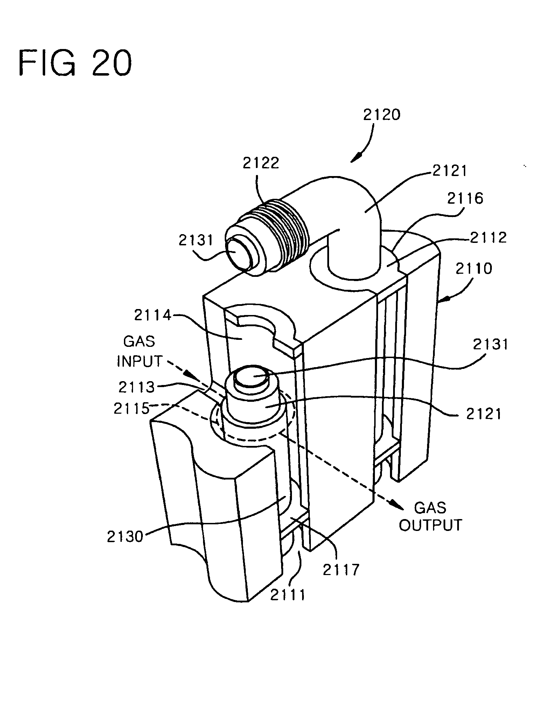

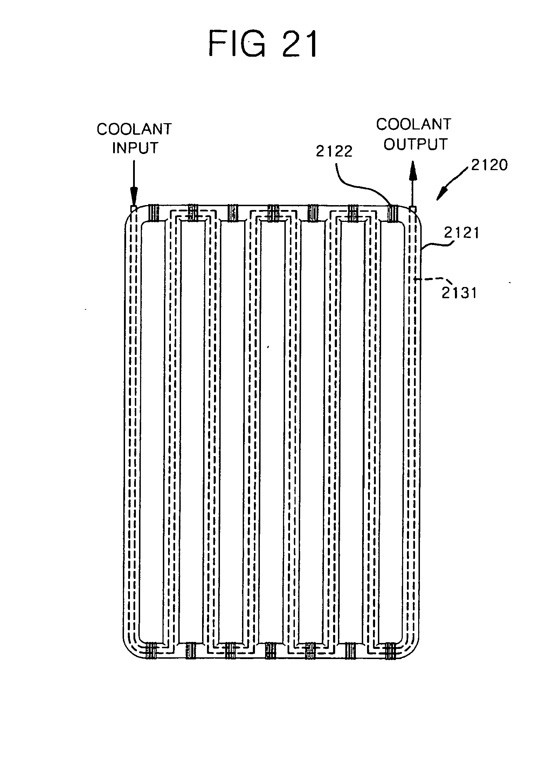

FIG. 20 is a partial cut view of a reactor body 2110 with a magnetic core 2121, a core protecting tube 2130 and a cooling channel 2131 which are mounted in a discharge chamber 2114. FIG. 21 is an example of a cooling channel 2131 positioned along a magnetic core 2121. The center of the magnetic core 2121 is hollow, and the cooling channel 2131 is formed along the hollow region of the magnetic core 2121. For example, as shown in FIG. 21, the cooling channel 2131 may be installed zigzag, along the magnetic core 2121.

Although not shown in the drawings, the cooling channel may be formed in the reactor body 2110, and the cooling channel may be a tube shape surrounding the magnetic core 2121. When the tube-type cooling channel surrounding the magnetic core 2121 is made of a metal material, it is preferable to form the insulation region to prevent the eddy current. The cooling channel 2131 may be positioned in the magnetic core 2121 or the reactor body 2110, or it may be positioned so as to surround the outside of the magnetic core 2121. That is, the position of the cooling channel 2131 may be selected from any one of the above or a combination thereof. In FIG. 20, reference number '2115' marked in dotted line represents a gas flow path and a plasma discharge path.

When the length of the discharge chambers 2114 is long, the discharge region is divided into two or more regions by one or more discharge dividing partitions 2117, so that the plasma discharge is stabilized and the plasma is uniformly generated. The discharge dividing partitions 2117 are made of the electrical insulating material such as quartz or ceramic. Alternatively, the discharge dividing partitions 2117 may be made of the same metal material as the reactor body 2110, and in this case, it is preferable to include the insulation region of the electrical insulating material for the electrical discontinuity to prevent the eddy current.

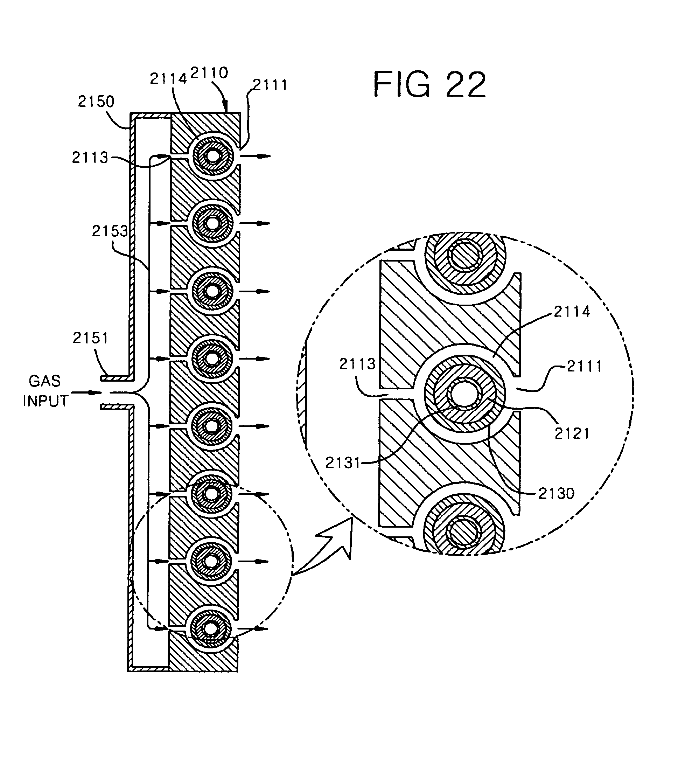

FIG. 22 is a sectional view of a plasma reactor 2100 and a partial enlarged view of a discharge chamber 2114. Referring to FIG. 22, a gas supply unit 2150 is positioned at the rear side of a reactor body 2110. Each discharge chamber 2114 includes a gas injection opening 2113. A number of gas injection openings 2113 are formed, along the longitudinal direction of the discharge chambers 2114. The gas inputting to a gas entrance 2151 of the gas supply unit 2150 is distributed along the distribution path with reference number 2153 marked as the arrows, and is evenly injected into a number of discharge chambers 2114 through the gas injection openings 2113. As not specifically shown in the drawing, preferably, one or more gas dividing partitions for gas distribution may be positioned in the gas supply unit 2150.

As described above, in the plasma reactor 2100, the current of the primary winding 2122 is driven by the power supply source 2140, and the driving current of the primary winding 2122 completes the secondary circuit of the transformer 2120, so that an AC potential forming the inductive coupled plasma is formed in the discharge chambers 2114. As a result, the inductive coupled plasma surrounding an outside of the core protecting tube 2130 is formed in each discharge chamber 2114. The formed plasma is jetted on the whole, through each plasma jet slit 2111.

The plasma reactor 2100 uniformly generates the large-area high-density plasma. Specifically, to obtain the plasma in a desired form, the plasma reactor 2100 is easily expanded, by increasing the number and length of the discharge chambers 2114. The structure of the plasma reactor 2110 is constituted to be very thin, thereby minimizing the equipment area.

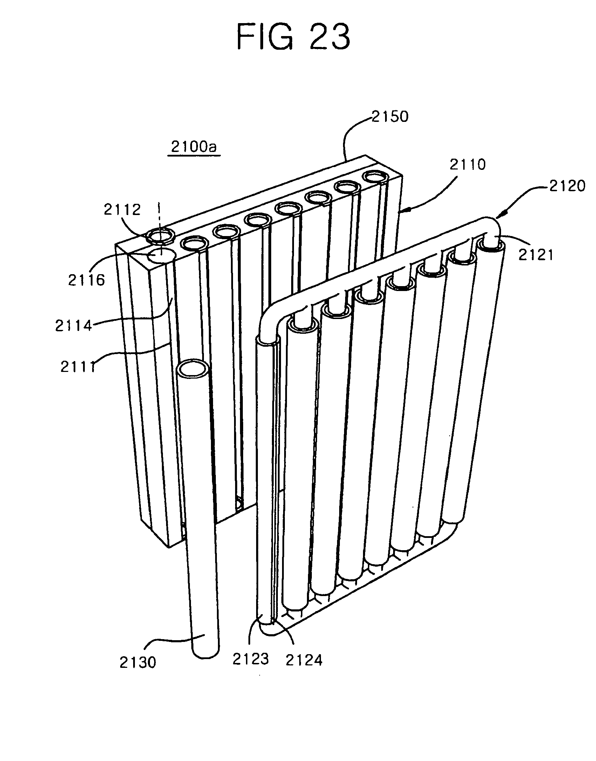

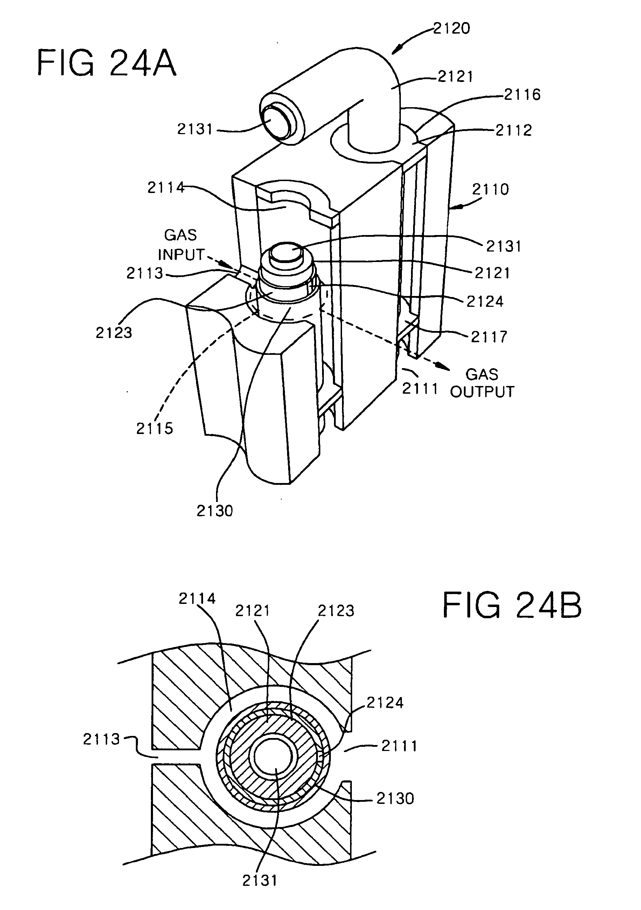

FIG. 23 is an exploded perspective view of another modified plasma reactor 2100a. FIGS. 24A and 24B are a partial cut view and a partial enlarged sectional view of a multiple discharge chamber in which a magnetic core 2121, a core protecting tube 2130, a coolant supply pipe and a primary winding 2123 are mounted. Referring to the drawings, the modified plasma reactor 2100a basically has the same constitution as the plasma reactor 2100 described above, except for the following difference: The plasma reactor 2100 has the structural feature that the primary winding 2122 is wound around parts of the magnetic core 2121 exposed outward the reactor body 2110. However, the modified plasma reactor 2100a has the structural feature that the primary winding 2123 is mounted at part of the magnetic core 2121 positioned inside the core protecting tube 2130. Specifically, the primary winding 2123 is a winding coil once wound around each loop of the magnetic core 2121, and includes a tube-type conductive member. The tube-type conductive member includes an insulation region 2124 with the electrical insulating material formed longitudinally, to prevent the eddy current.

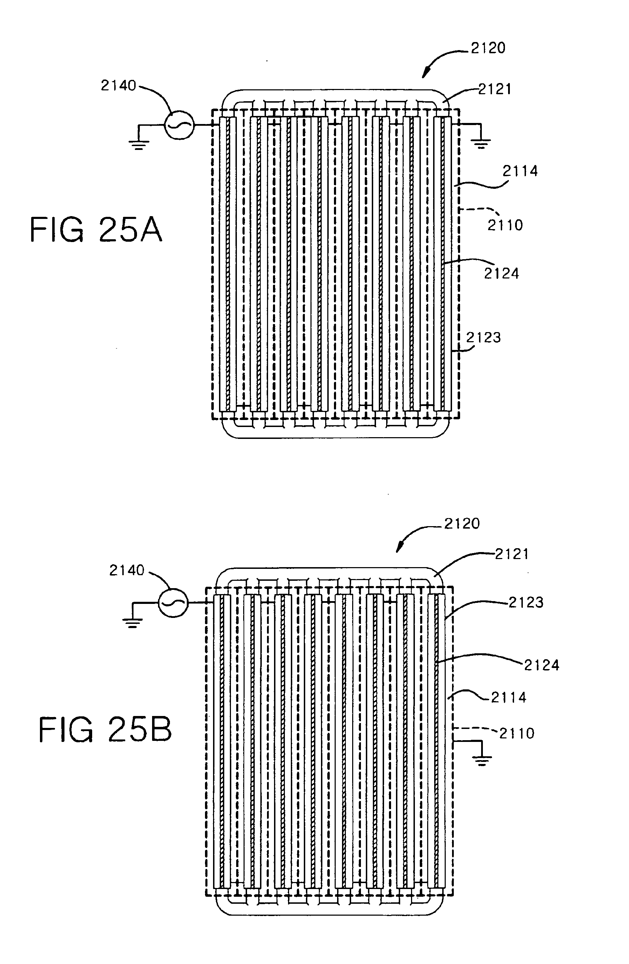

FIGS. 25A through 25C are examples of an electrical connection structure of a first power supply source 2140 and a primary winding 2123.

Referring to FIG. 25A, each primary winding 2123 of the plasma reactor 2100a is positioned in each discharge chamber 2114, and is connected to the first power supply source 2140 in series. The electrical connection method of the primary winding 2123 and the first power supply source 2140 may be selected from a series method, a parallel method, or a series/parallel combination method.

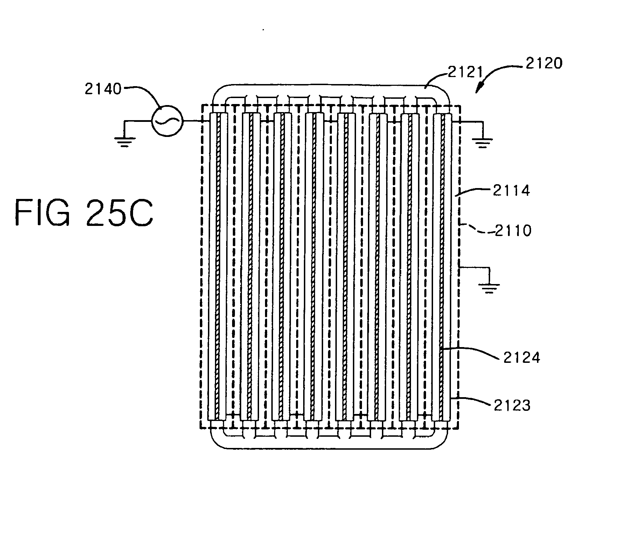

Referring to FIG. 25B, the primary winding 2123 in the plasma reactor 2100a is capable of a capacitive coupled electrode. For this purpose, a reactor body 2110 is connected to a ground. The primary winding 2123 is connected to the first power supply source 2140 but not connected to the ground. As shown in FIG. 25C, the primary winding 2123 may be connected to the ground.

The modified plasma reactor 2100a and the plasma reactor 2100 are basically same as each other but are different with respect to their technical features of the primary winding 2123. That is, in the modified plasma reactor 2100a, the primary winding 2123 acts as the primary winding of the transformer 2120 and the electrode capacitively coupled with the reactor body 2110. As a result, in the modified plasma reactor 2100a, at the same time when the inductive coupled plasma is generated by the transformer 2120, the capacitive coupled plasma is generated between the plasma reactor 2100a and the reactor body 2110.

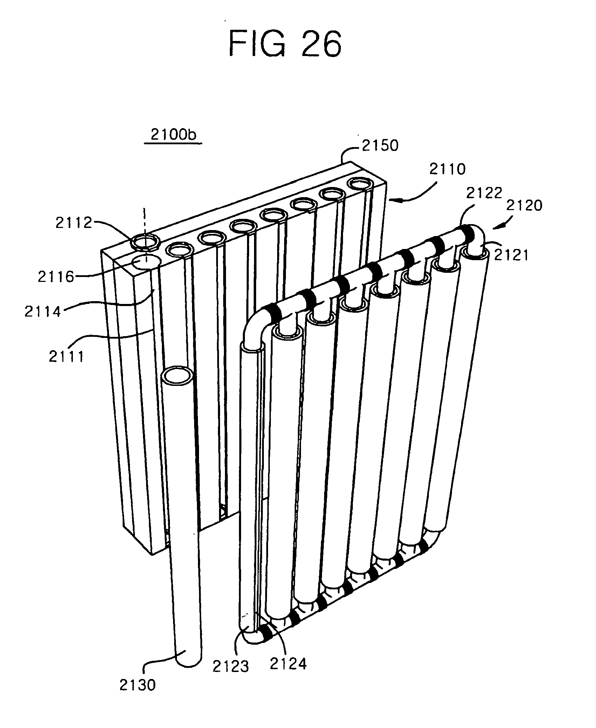

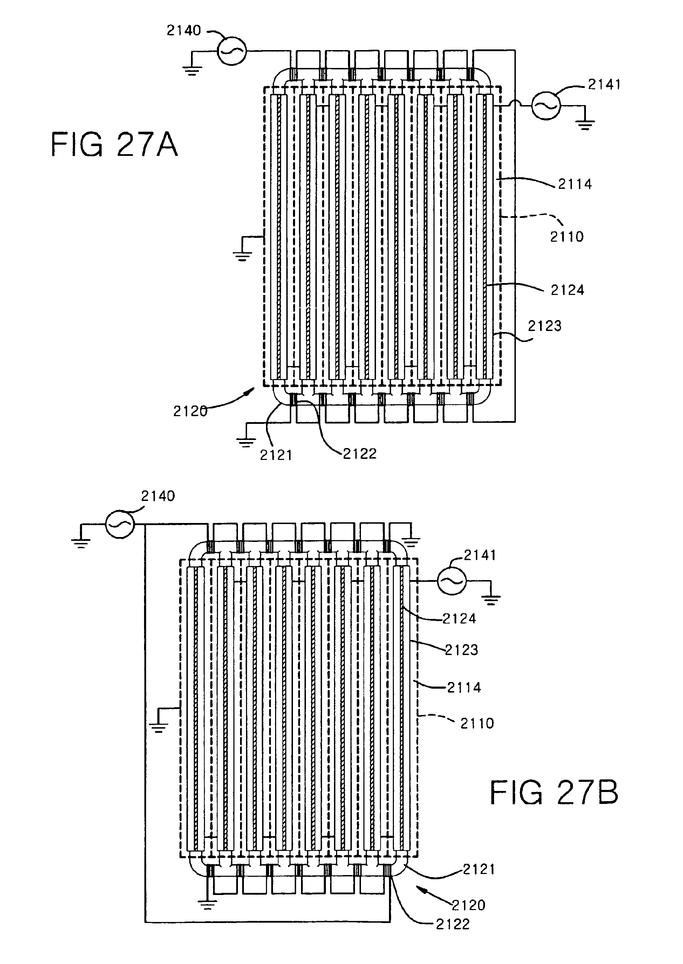

FIG. 26 is an exploded perspective view of another modified plasma reactor 2100b. Referring to FIG. 26, the modified plasma reactor 2100b has the basically same constitution as the plasma reactor 2100 described above. However, the modified plasma reactor 2100b includes both of the primary winding 2122 (hereinafter, referred to as a 'first primary winding') of the plasma reactor 2100 and the primary winding 2123 (hereinafter, referred to as a 'second primary winding') of the modified plasma reactor 2100a. As shown in FIGS. 27A and 27B, the second primary winding 2123 is connected to an additional second power supply source 2141. The second power supply source 2141 is an alternating current (AC) power supply source supplying the RF power. Although not shown in the drawings, an impedance matching box may be positioned at an output terminal of the second power supply source 2141. However, those skilled in this art may understand that the RF power supply source capable of controlling the output voltage without a separate impedance matching box may be used.

FIGS. 27A through 27C are examples of an electrical connection structure of a first power supply source 2140 and a second power supply source 2141 and a primary winding. Referring to FIGS. 27A and 27B, the first primary winding 2122 may be connected to the first power supply source 2140 in series, in parallel, or in a series/parallel combination, as described with respect to the first comparative example. The second primary winding 2123 may be also connected to the second power supply source 2141 2140 in series, in parallel, or in a series/parallel combination, as described with respect to the modified plasma reactor.

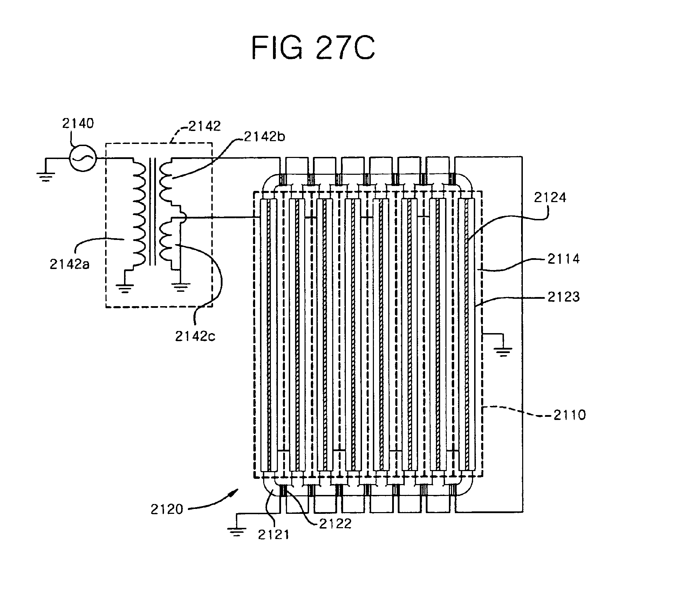

Referring to FIG. 27C, the first and second primary windings 2122 and 2123 supply power, by using the first power supply source 2140 and a power distributor 2142. The power distributor 2142 is formed, by using the transformer. A first winding 2142a of the transformer is connected to the first power supply source 2140, and a secondary winding is divided into two windings 2142b and 2142c, which are connected to the first and second primary windings 2122 and 2123, respectively. The winding ratio of the divided secondary windings 2142b and 2142c may be fixed or variable.

In the modified plasma reactor 2100b, the second primary winding,2123 is capable of the capacitive coupled electrode as described above, and the reactor body 2110 is connected to the ground. The second primary winding 2123 may be connected to the ground or not.

As described above, the plasma reactor including a multiple discharge chamber according to the fourth embodiment of the present invention is capable of uniformly generating the large-area high-density plasma. Specifically, to obtain the large-area plasma in a desired form, the plasma reactor can be easily expanded, by increasing the number and length of the discharge chambers. The plasma reactor can be structured to be very thin, thereby minimizing the equipment area. For example, when the plasma reactor is vertically positioned in a vertical plane or it may be horizontally positioned in a horizontal plane so as to form a multi layer structure, the equipment area does not largely increase and the processing volume per equipment area greatly increases.

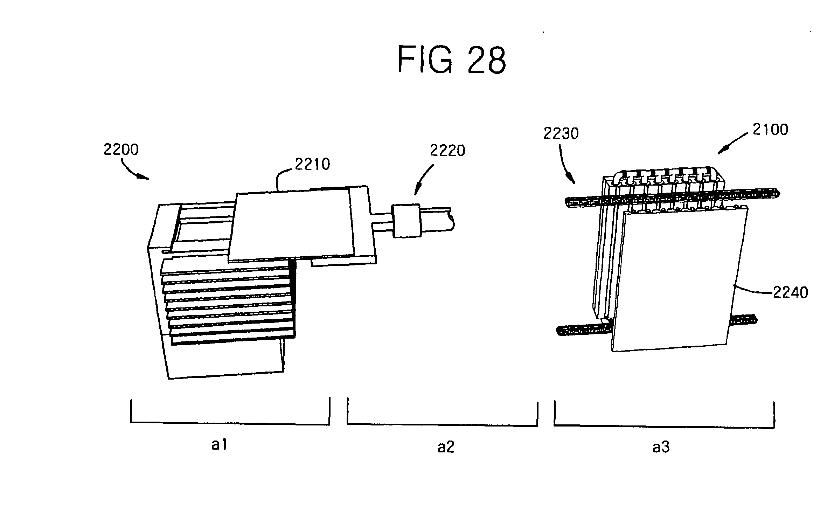

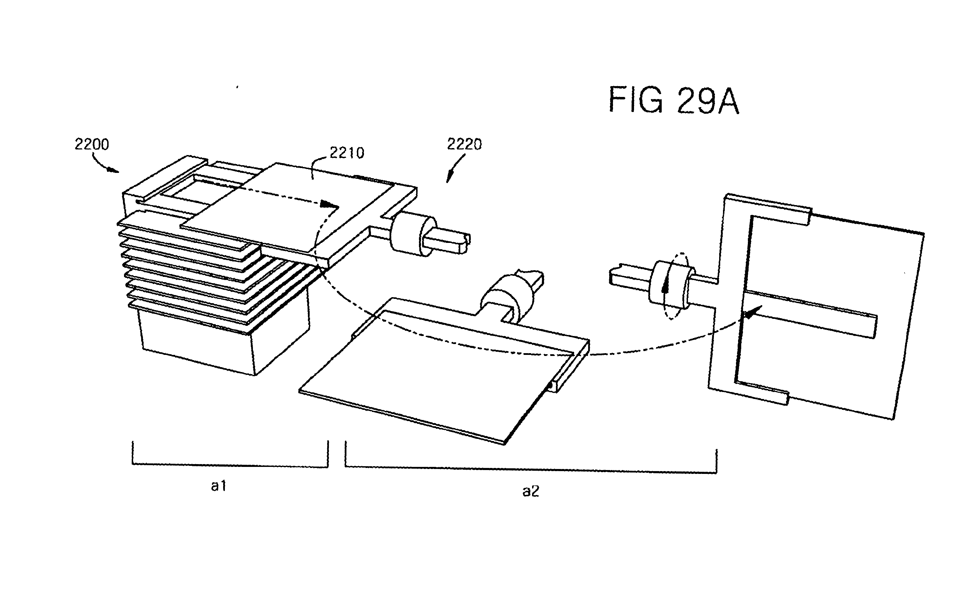

FIG. 28 is a schematic constitutional view of an atmospheric pressure plasma processing system using the plasma reactor according to the third comparative example. FIGS. 29A through 29C are views sequentially illustrating a process of transferring a workpiece substrate in the atmospheric pressure plasma processing system. Referring to the drawings, the atmospheric pressure plasma processing system performs plasma processing on a workpiece to be processed at atmospheric pressure, using the plasma reactor 2100. In the atmospheric pressure plasma processing system, a first workpiece standby unit where a workpiece 2210 is on standby is positioned at the front line, and a atmospheric pressure processing unit a3 is positioned at the rear. A first transfer unit a2 is positioned between the first workpiece standby unit a1 and the atmospheric pressure processing unit a3.

The first workpiece standby unit a1 includes a carrier 2200 in which the workpiece 2210 is stacked and kept. The workpiece 2210 may be, for example, a glass substrate for manufacturing a liquid crystal display, or a large silicon wafer substrate. The first transfer unit a2 includes a first transfer robot 2220. In the first transfer robot 2220, only one robot arm is simply illustrated for clarity. The first transfer robot 2220 transfers the workpiece 2210 between the first workpiece standby unit a1 and the atmospheric pressure processing unit a3.

In the atmospheric pressure processing unit a3, the plasma reactor 2100 is vertically positioned and performs the plasma processing on the workpiece 2210 at the atmospheric pressure, by using the plasma jetting through the plasma jet slits 2111. The atmospheric pressure processing unit a3 includes a transfer means 2230 to vertically transfer the workpiece 2210 in the front and the rear. The transfer means 2230 may be, for example, a conveyer system including a number of rollers, or any other transfer means not shown may be used.

The atmospheric pressure processing unit a3 may include a preheating means 2240 to preheat the workpiece 2210. The preheating means 2240 may include, for example, a number of halogen lamps and reflex shades. The preheating means 2240 may be positioned to face the plasma reactor 2100 or it may be positioned between the first transfer unit a2 and the atmospheric pressure processing unit a3. The preheating means 2240 may act as a heater continuously heating the workpiece 2210 during the plasma processing, if necessary.

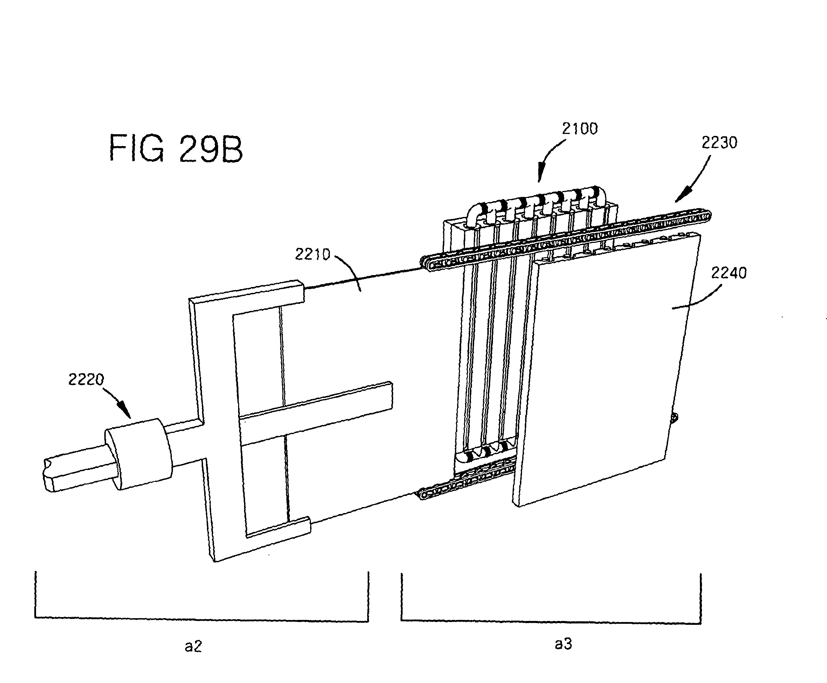

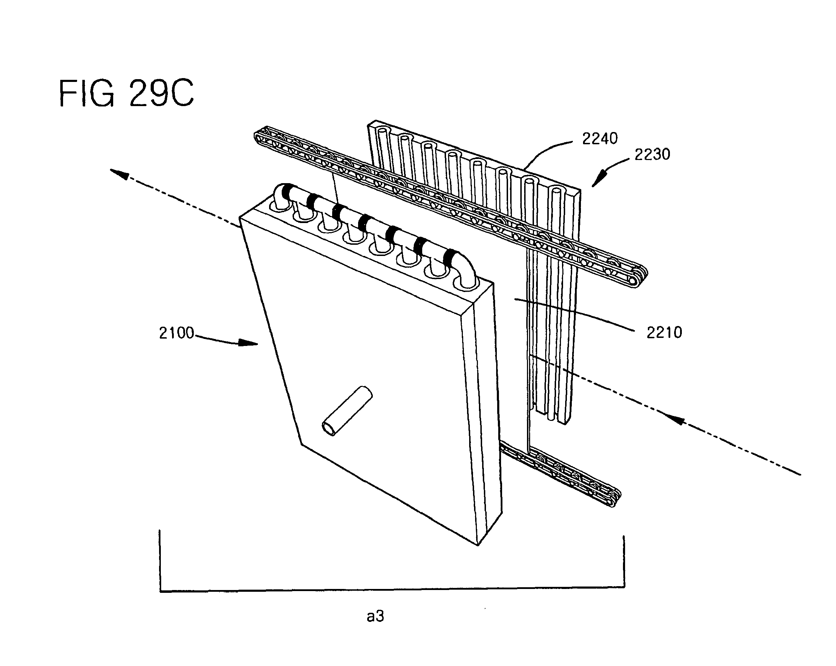

The plasma reactor 2100 is vertically installed in the atmospheric pressure processing unit a3. The workpiece 220 is vertically input into and output from the atmospheric pressure processing unit a3. For this purpose, the first transfer robot 2220 positioned in the first transfer unit a2 changes a position of the workpiece 2210 from the horizontal to the vertical, as shown in FIG. 29A, and transfers the workpiece 2210 to the transfer means 2230 of the atmospheric pressure unit a3, as shown in FIG. 29B. Then, the transfer means 2230 enters the input workpiece 2210 to the front of the plasma reactor 2100, as shown in FIG. 29C. The plasma reactor 2100 performs the plasma processing on the workpiece 2210. When the plasma processing is completed, the workpeice 2210 is transferred in reverse order, from the atmospheric pressure processing unit a3 to the first transfer unit a2. The processed workpiece 2210 is changed from its vertical position to its horizontal, by the first transfer robot 2220, and is stacked in the carrier 2200 of the first workpiece standby unit a1.

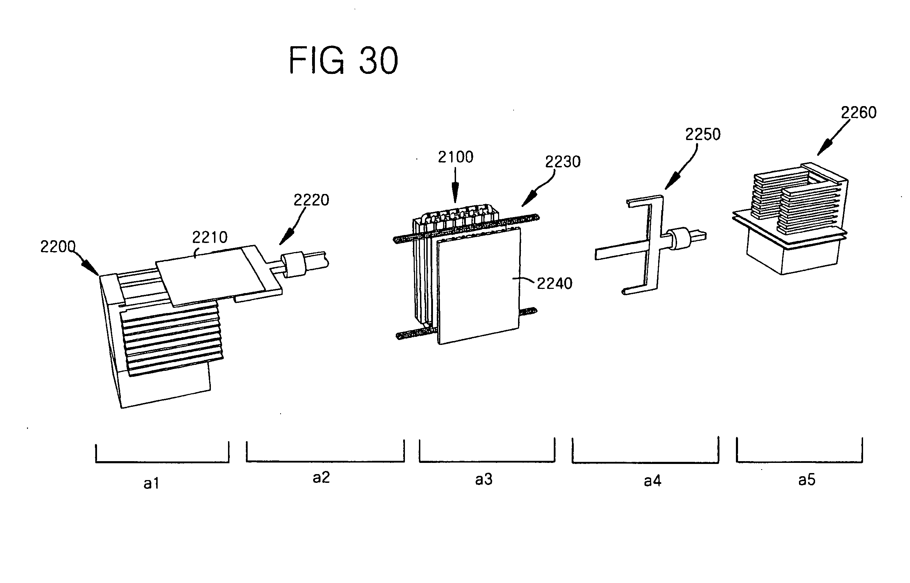

FIG. 30 is a schematic constitutional view of the atmospheric pressure plasma processing system in a First-In-Last-Out structure. Referring to FIG. 30, the atmospheric pressure plasma processing system may have the First-In-Last-Out structure, by including first and second workpiece standby units a1 and a5 at the front of an atmospheric pressure processing unit a3 and first and second transfer units a2 and a4 at the rear thereof. A workpiece which is not yet processed is on standby at the first workpiece standby unit a1, and a workpiece which has been processed is on standby at the second workpiece standby unit a5. A first transfer robot 2220 positioned in the first transfer unit a2 loads the workpiece to the atmospheric pressure processing unit a3, and a second transfer robot 2250 positioned in the second transfer unit a4 unloads the workpiece from the atmospheric pressure processing unit a3.

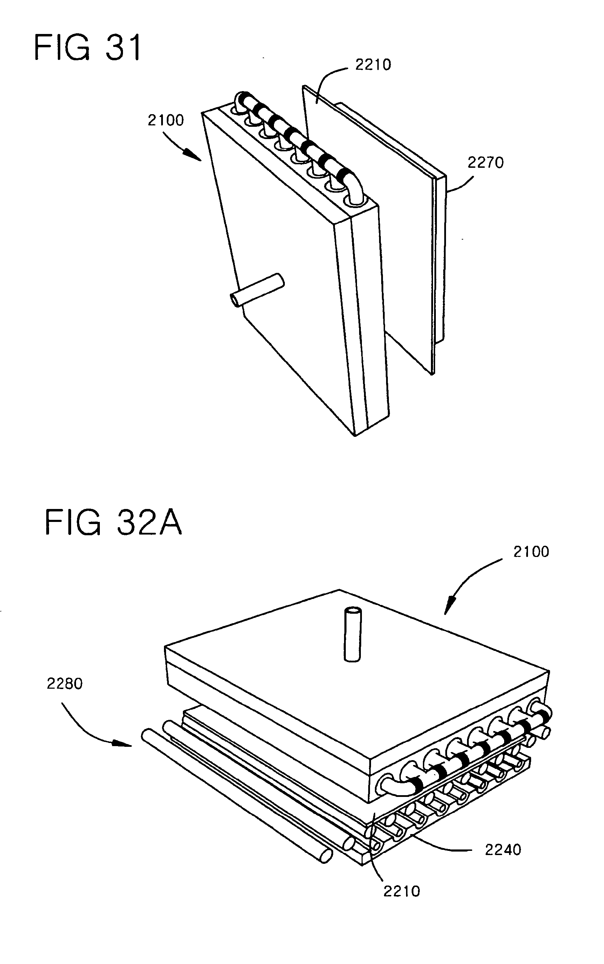

FIG. 31 is an example of an atmospheric pressure processing unit a3 including an electrostatic chuck 2270. The atmospheric pressure processing unit a3 may include the electrostatic chuck 2270 as a fixing means to fix and support a workpiece 2210 while the plasma processing is performed. The electrostatic chuck 2270 may include a heat inside.

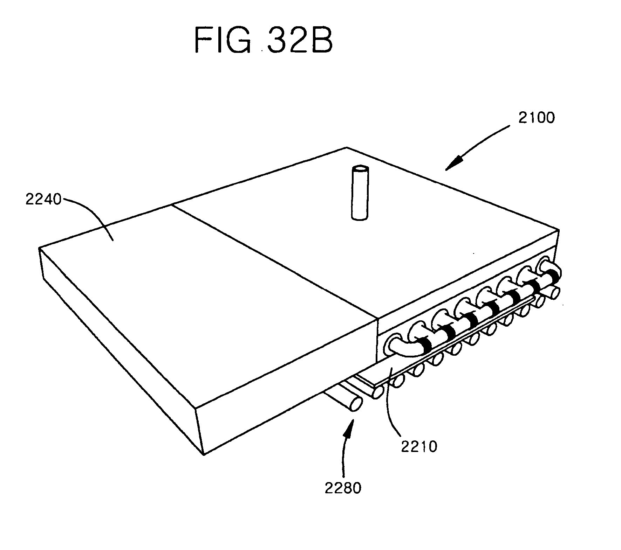

FIGS. 32A and 32B are examples of a plasma reactor 2100 which is horizontally positioned. In an atmospheric pressure plasma processing system, the plasma reactor 2100 may be horizontally positioned at an atmospheric pressure processing unit a3. As shown in FIG. 32A, a preheating means 2240 may be positioned to face the plasma reactor 2100. Alternatively, as shown in FIG. 32B, the preheating means 2240 may be positioned at the front of the plasma reactor 2100. A transfer means 2280 may include a conveyer system with a number of horizontal rollers. In the atmospheric pressure plasma processing system, the plasma reactor 2100 may be vertically or horizontally positioned.

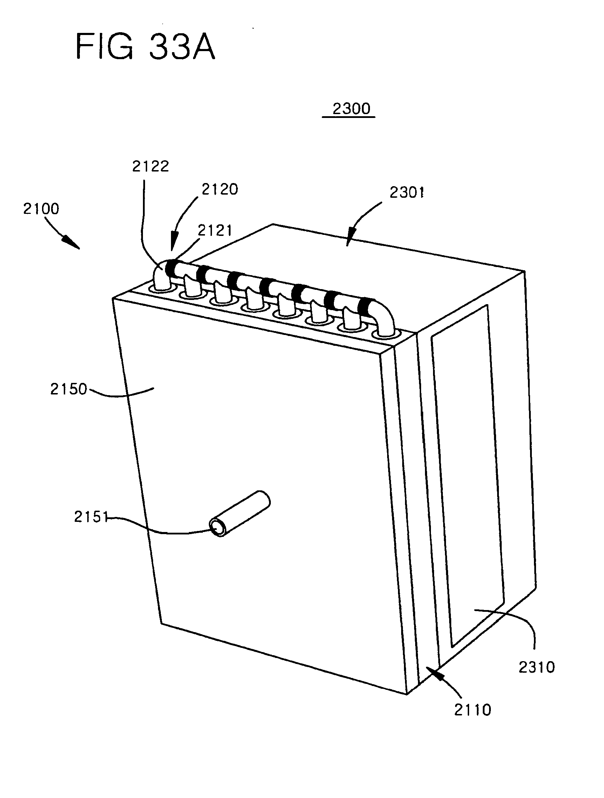

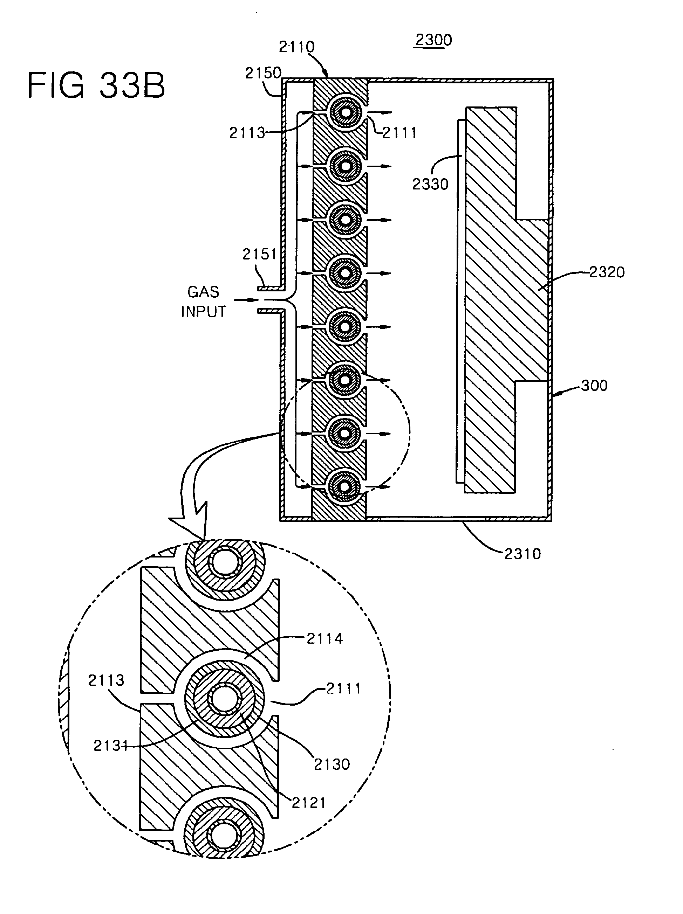

FIG. 33A is a perspective view of a plasma processing chamber 2300 using the plasma reactor according to the third comparative example; and FIG. 33B is a sectional view of the plasma processing chamber and a partial enlarged view of a discharge chamber 2114. The plasma processing chamber 2300 includes a plasma reactor 2100, a gas supply unit 2150 supplying a gas to the plasma reactor 2100, and a chamber housing 2301 receiving plasma generated in the plasma reactor 2100 and including a substrate support 2320 inside.

In the plasma processing chamber 2300, plasma jet slits 2111 of the plasma reactor 2100 and the substrate support 2320 are vertically positioned to face each other. As described below, a workpiece substrate 2330 is vertically input into the plasma processing chamber 2300 and is fixed to the substrate support 2320, so that the workpiece substrate 2330 is plasma-processed in its vertical position. The plasma processing chamber 2300 performs various plasma processes such as ashing to remove a photoresist by using the plasma, deposition of an insulation layer or metal layer, or etching, with respect to the workpiece substrate 2330.

Although not specifically shown in the drawings, in the plasma processing chamber 2300, the plasma jet slits 2111 of the plasma reactor 2100 and the substrate support 2320 may be horizontally positioned to face each other. In this case, the workpiece substrate 2330 is horizontally input into the plasma processing chamber 2300 and fixed to the substrate support 2320, so that the workpiece substrate 2330 is plasma-processed in its horizontal position.

A gas supply unit 2150 is positioned at the rear of a reactor body 2110. A number of discharge chambers 2114 include gas injection openings 2113, respectively. Although not shown in the drawings, a number of gas injection openings 2113 are formed, along the longitudinal direction of the discharge chambers 2114. A gas input into a gas entrance 2151 of the gas supply unit 2150 is distributed along a gas distribution path with reference number 1153 marked as the arrows, and is evenly injected into the discharge chambers 2114 through the gas injection openings 2113. Although not specifically shown in the drawings, preferably one or more gas separating partitions for gas distribution may be positioned in the gas supply unit 2150.

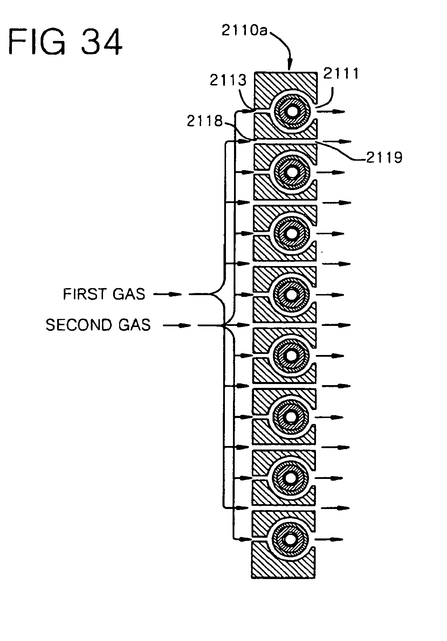

FIG. 34 is a sectional view of a reactor body 2110a having a separated gas supply structure. The modified reactor body 2110a may have a gas supply structure separated as two parts. For example, the reactor body 2110a includes first gas injection openings 2113 opened in plasma discharge chambers 2114, and second gas injection openings 2118 formed between two adjacent plasma discharge chambers 2114 and opened in the chamber housing.

The gas input through the first gas injection openings 2113 passes through the plasma discharge chambers 2114 and is exhausted through the plasma jet slits 2111. The gas input through the second gas injection openings 2118 is exhausted through gas jet openings 2119. The gas jetting through the gas jet openings 2119 is ionized by the plasma gas output through the plasma jet slits 2111. Although not shown in the drawing, the gas supply unit 2150 includes separated gas supply paths which separately supply different gases to the first and second gas injection openings 2113 and 2118, and appropriate gas dividing partitions and gas entrance.

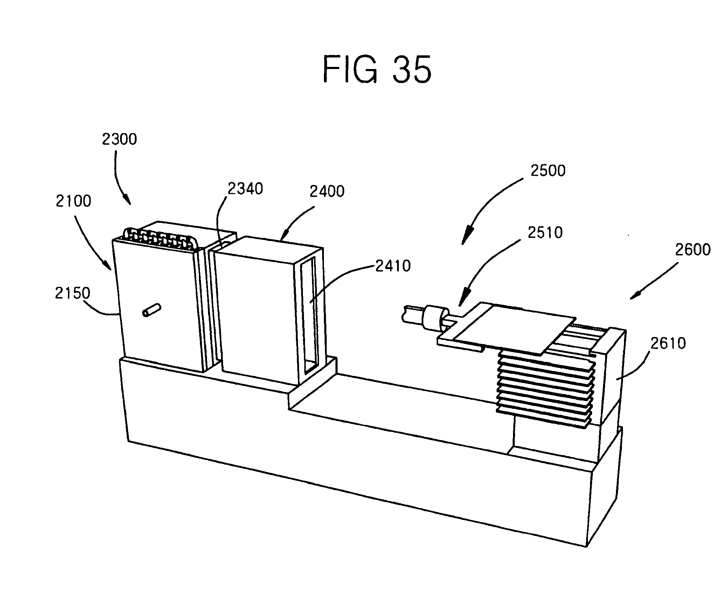

FIG. 35 is a schematic constitutional view of a plasma processing system. The plasma processing system plasma-processes a workpiece substrate, by using the plasma processing chamber 2300. The plasma processing system includes a loadlock chamber 2400 connected to the plasma processing chamber 2300. The loadlock chamber 2400 is connected to a transfer chamber 2500. A workpiece substrate standby chamber 2600 is positioned at the front of the transfer chamber 2500. The workpiece substrate standby chamber 2600 includes a carrier 2610 where a workpiece 2210 is stacked and kept. The workpiece 2210 may be, for example, a glass substrate for manufacturing a liquid crystal display, or a large silicon wafer substrate.

A slit valve 2340 is positioned between the loadlock chamber 2400 and the plasma processing chamber 2300. The slit valve 2340 has a structure of opening and closing a substrate entrance 2412 (not shown) of the loadlock chamber 2400 and a substrate entrance 2310 (not shown) of the plasma processing chamber 2300. The loadlock chamber 2400 includes another substrate entrance 2410 toward the transfer chamber 2500, and the substrate entrance 2410 is opened and closed by another slit valve. When the workpiece substrate is transferred from and to the plasma processing chamber 2300, the loadlock chamber 2400 maintains the same vacuum state as the inside of the plasma processing chamber 2300. When the workpiece substrate is transferred from and to the transfer chamber 2500, the loadlock chamber 2400 maintains the atmospheric pressure state.

The loadlock chamber 2400 includes a first transfer robot 2420 transferring the workpiece substrate between the plasma processing chamber and the loadlock chamber 2400. The transfer chamber 2500 includes a seond transfer robot 2510 transferring the substrate between the workpiece substrate standby chamber 2600 and the loadlock chamber 2400.

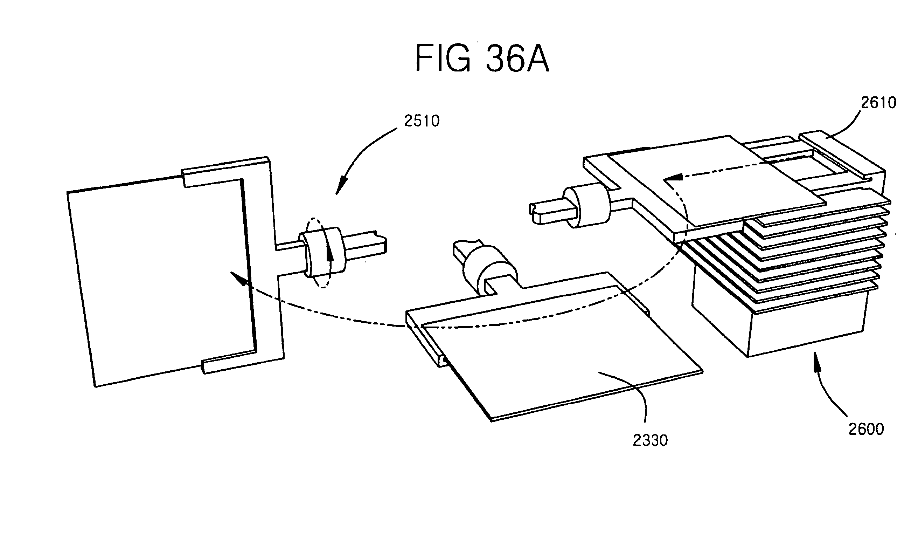

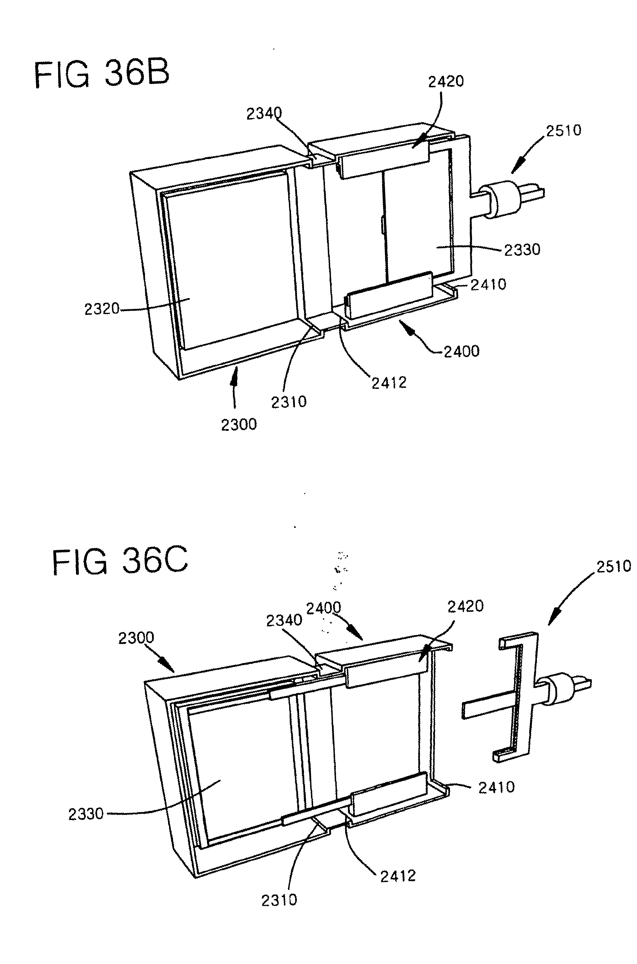

FIGS. 36A through 36C are views sequentially illustrating a process of transferring a workpiece substrate 2330 in a plasma processing system. A second transfer robot 2510 transfers the workpiece substrate 2330 loaded in a carrier 2610 to a first transfer robot 2420. Here, the second transfer robot 2420 changes a position of the workpiece substrate 2330 from the horizontal to the vertical, and transfers it to the first transfer robot 2420.

The first transfer robot 2420 transfers the workpiece substrate 2330 vertically positioned to a substrate support 2320 of a plasma processing chamber 2300. The substrate support 2320 fixes the workpiece substrate 2330 during the plasma process. The first transfer robot 2420 may include two double arms to exchange two sheets, i.e., the workpiece substrates before and after the plasma process. The second transfer robot 2510 may include two double arms to exchange and transfer two sheets, i.e., the workpiece substrates before and after the plasma process, to the loadlock chamber 2400.

The substrate supports 2320 includes a fixing means to fix the substrate, for example, an electrostatic chuck, or any other fixing means. The substrate support may include a heater as a heating means to heat the workpiece substrate. Or a light-heating means may be positioned inside the chamber housing, so that the workpiece substrate is heated by light emission. It is apparent that the plasma processing chamber 2300 may additionally include necessary components for the intended plasma processing on the workpiece substrate.

The loadlock chamber 2400 may additionally include any necessary constitution for preheating the workpiece substrate 2330 before it is transferred to the plasma processing chamber 2300 and/or for cooling the heated substrate after the plasma processing is completed.

The plasma processing system may include another loadlock chamber, another transfer chamber and another workpiece substrate standby chamber which are symmetrically positioned around the plasma processing chamber 2300. That is, the plasma processing system may have the First-In-Last-Out structure, in which the workpiece substrate to be process is loaded to the plasma processing chamber 2300 at the front of the plasma processing chamber 2300, and the processed workpiece substrate is unloaded at the rear of the plasma processing chamber 2300.

In the plasma processing chamber including the plasma reactor with multiple discharge chambers, and in the plasma processing system using the same according to the embodiments of the present invention, the plasma reactor uniformly generates the large-area high-density plasma. Specifically, to obtain the large-area plasma in a desired form, the plasma reactor can be easily expanded, by increasing the number and length of the discharge chambers. The plasma reactor can be constituted to be very thin, thereby minimizing the equipment area. For example, when the plasma reactor is vertically stood and positioned, or it is horizontally positioned to form a multiple structure, the equipment area is not expanded largely and the processing volume per equipment area is greatly increased.

The plasma source with discharge inducing bridges and the plasma processing system using the same in accordance with the comparative examples and the embodiment of the present invention may be variously modified and have different shapes. Thus, while the present invention has been particularly shown and described with reference to an exemplary embodiment thereof, it will be understood by those of ordinary skill in the art that various changes in form and details may be made therein. The invention is defined by the claims.

## Claims

1. A plasma processing chamber comprising:
a chamber housing (1110) including at least one susceptor (1101) on which, in use, a workpiece substrate is placed;
a number of discharge inducing bridges (1300) positioned within the chamber housing;
a number of holes (1113) formed in the chamber housing, for receiving both ends of each discharge inducing bridge;
a transformer having a magnetic core (1310) mounted in each discharge inducing bridge, and a primary winding (1312); and
a first power supply source (1400) electrically connected to the primary winding, the first power supply source (1400) being arranged to
, in use, drive a current at the primary winding and induce a magnetic flux at the magnetic core (1310) thereby inducing an AC potential inside the chamber housing which forms an inductive coupled plasma around the discharge inducing bridges to complete a secondary circuit of the transformer;
**characterised by** further comprising a discharge shade (1250) or a gas jet plate (1210) arranged to be, in use, electrically grounded and operatively positioned above the discharge inducing bridges;
wherein the discharge shade (1250) or the gas jet plate (1210) includes a first gas supply channel (1252, 1211) arranged to flow a first gas to just above the discharge inducing bridges, and a second gas supply channel (1254, 1212) arranged to flow a second gas to between the discharge inducing bridges.

2. The plasma processing chamber according to claim 1, further comprising a first impedance matching box electrically connected between the first power supply source (1400) and the primary winding (1312).

3. The plasma processing chamber according to claim 1, further comprising:
a second power supply source (1410) supplying bias power to the susceptor.

4. The plasma processing chamber according to claim 1, further comprising a gas supply unit in a separate gas supply structure including the first gas supply channel (1211) for flowing a first gas to just above the discharge inducing bridges, and the second gas supply channel (1212) for flowing a second gas to between the discharge inducing bridges.

5. The plasma processing chamber according to claim 1, wherein the magnetic core (1310) includes a closed core with a single loop.

6. The plasma processing chamber according to claim 1, wherein the magnetic core (1310) includes a closed core with a multiple loop.

7. The plasma processing chamber according to claim 1, wherein, in use, the susceptor receives one or more bias power.

8. The plasma processing chamber according to claim 1, further comprising one or more discharge separating partitions (1340) dividing a plasma formation region formed by the discharge inducing bridges into a number of regions.

9. The plasma processing chamber according to claim 1, further comprising a ground electrode (1330) operatively positioned inside the discharge inducing bridge, to face the susceptor.

10. The plasma processing chamber according to claim 1, wherein the discharge shade (1250) includes one or more discharge separating partitions dividing the plasma formation region formed by the discharge inducing bridges into one or more regions.

## Patentansprüche

1. Ein Plasmaprozesskammer umfassend:
eine Kammergehäuse (1110) mit mindestens einem Suszeptor (1101) auf dem, im Gebrauch, ein Werkstücksubstrat angeordnet ist;
eine Anzahl von Entladunginduzierbrücken (1300) innerhalb der Kammergehäuse;
einer Anzahl von in der Kammergehäuse gebildeten Löchern (1113), für den Empfang von beiden Enden jeder Entladunginduzierbrücke;
einen Transformator mit einem magnetischen Kern (1310) montiert in jeder Entladunginduzierbrücke und eine Primärwicklung (1312), und
eine erste Stromversorgungsquelle (1400) elektrisch mit der Primärwicklung verbunden,
die erste Stromversorgungsquelle (1400) dazu ausgebildet ist, in Einsatz, einen Strom von der Primärwicklung zu steuern und ein Magnetfluss an dem magnetischem Kern zu induzieren **dadurch** eines induktiv gekoppeltem Plasma um die Entlastunginduzierbrücken zu bilden und einem Sekundärkreis des Transformartors abzuschlossen;
**gekennzeichnet durch** eine Entladungsschirm (1250) oder eine Gasstrahlplatte (1250) die dazu ausgebildet ist, in Einsatz, elektrisch geerdet und operativ über die Entlastunginduzierbrücken positioniert zu sein;
wobei die Entladunsschirm (1250) oder Gasstrahlplatte (1210) umfasst einen ersten Gaszuführkanal (1252,1211), der dazu ausgebildet ist ein erstes Gas bis knapp über die Entlastunginduzierbrücken zu strömen, und eine zweite Gaszuführkanal (1254,1212), der dazu ausgebildet ist ein zweites Gas zwischen der Entladung induziert Brücken zu strömen.

2. Die Plasmaprozesskammer nach Anspruch 1, umfassend einen erste Impedanzanpassungkasten elektrisch zwischen dem ersten Stromversorgungsquelle (1400) und der Primärwicklung (1312) verbunden.

3. Die Plasmaprozesskammer nach Anspruch 1, umfassend:
ein zweites Stromversorgungsquelle (1410) das Vorspannungsström der Suszeptor versorgt.

4. Die Plasmaprozesskammer nach Anspruch 1, weiter umfassend eine Gasversorgungseinheit in einem getrennt Gasversorgunsstruktur, die eine erste Gaszuführkanal (1211) um ein erstes Gas bis knapp über die Entladunginduzierbrücken zu strömen aufweist, und eine zweite Gaszuführkanal (1212) um ein zweites Gas zwischen die Entladunginduzierbrücken zu strömen aufweist.

5. Die Plasmaprozesskammer nach Anspruch 1, wobei der magnetische Kern (1310) einen geschlossenen Kern mit einem Schleife aufweist.

6. Die Plasmaprozesskammer nach Anspruch 1, wobei der magnetische Kern (1310) einen geschlossenen Kern mit mehreren Schleifen aufweist.

7. Die Plasmaprozesskammer nach Anspruch 1, wobei, im Einsatz, der Suszeptor eine oder mehrere Vorspannungsströme erhalt.

8. Die Plasmaprozesskammer nach Anspruch 1, weiter umfassend einen oder mehrere Entladungstrennwände (1340), die ein die Entladunginduzierbrücken gebildtetenPlasmabildungregion in einer Reihe von Regionen teilt.

9. Die Plasmaprozesskammer nach Anspruch 1, weiter umfassend eine Masseelektrode (1330) operativ in die Entladunginduzierbrücke positioniert, den Suszeptor gegenüber.

10. Die Plasmaprozesskammer nach Anspruch 1, wobei die Entladungsschirm (1250) einen oder mehrere Entladungstrennwände aufweist, die ein die Entladunginduzierbrücken gebildtetenPlasmabildungregion in einer Reihe von Regionen teilt.

## Revendications

1. Une chambre de traitement au plasma comprenant:
un boîtier de chambre (1110) dont au moins un suscepteur (1101) sur laquelle, en utilisation, un substrat pièce est placée;
un certain nombre de ponts induisant la décharge (1300) positionné dans le logement de chambre;
un certain nombre de trous (1113) formée dans le boîtier de chambre, pour reçevoir les deux extrémités de chaque pont décharge inductrice;
un transformateur ayant un noyau magnétique (1310) monté dans chaque pont induisant la décharge, et un enroulement primaire (1312), et
une première source d'énergie d'alimentation (1400) relié électriquement à l'enroulement primaire,
la première source d'énergie d'alimentation (1400) agencé pour conduire un courant à l'enroulement primaire et induiser un flux magnétique au noyau magnétique qui forme un plasma inductif couplé autour des ponts induisant la décharge, et induise un potentiel alternatif à l'intérieur du boîtier à chambre,
pour compléter un circuit secondaire du transformateur;
**caractérisée par** comprenant en outre une ombre de décharge (1250) ou une plaque du jet de gaz (1210) agencé pour etre électriquement lié à la terre et opérativement positionné au-dessus des ponts induisant décharge;
dans laquelle l'ombre de décharge (1250) ou la plaque jet de gaz (1210) comprend un premier canal d'alimentation gaz (1252,1211) agencé pour couler un premier gaz juste au-dessus des ponts induisant la décharge, et un deuxième canal d'alimentation de gaz (1254,1212) agencé pour couler un deuxième gaz à l'entre les ponts induisant décharge.

2. La chambre de traitement à plasma selon la revendication 1, comprenant en outre une première boîte d'impédance électriquement connecté entre la première source alimentation (1400) et l'enroulement primaire (1312).

3. La chambre de traitement à plasma selon la revendication 1, comprenant en outre:
une seconde source d'énergie d'alimentation (1410) alimentant biais du suscepteur.

4. La chambre de traitement à plasma selon la revendication 1, comprenant en outre une unité d'alimentation de gaz dans une structure d'approvisionnement de gaz séparés, y compris le canal d'alimentation en gaz première (1211) pour couler un premier gaz juste au-dessus des ponts induisant la décharge, et le canal de gaz seconde offre (1212) pour couler un deuxième gaz à induction entre les ponts de décharge.

5. La chambre de traitement par plasma selon la revendication 1, dans lequel le noyau magnétique (1310) comprend un noyau fermé avec une boucle simple.

6. La chambre de traitement par plasma selon la revendication 1, dans lequel le noyau magnétique (1310) comprend un noyau fermé avec plusieurs boudes.

7. La chambre de traitement à plasma selon la revendication 1, dans lequel, dans l'utilisation, le suscepteur reçoit un ou plus de puissance de partialité.

8. La chambre de traitement à plasma selon la revendication 1, comprenant en outre un ou plusieurs de décharge (1340) des cloisons de séparation divisant une région de formation du plasma formé par les ponts induisant la décharge dans un certain nombre de régions.

9. La chambre de traitement à plasma selon la revendication 1, comprenant en outre une électrode de masse opératoire (1330) positionnée à l'intérieur du pont de la décharge induisant, pour faire face à l'suscepteur.

10. La chambre de traitement par plasma selon la revendication 1, dans lequel l'ombre de décharge (1250) comporte une ou plusieurs de décharge des cloisons de séparation divisant la zone de formation du plasma formé par les ponts induisant la décharge en une ou plusieurs régions.
